# EUROPÄISCHE PATENTSCHRIFT

(11) **EP 3 275 022 B1**
(45) Veröffentlichungstag und Bekanntmachung des Hinweises auf die Patenterteilung: **14.10.2020**
(21) Anmeldenummer: 16712011.2
(22) Anmeldetag: 21.03.2016
(51) Int. Cl.: H01L 33/64, B23K 26/22, B23K 26/24, H01L 23/36, H05K 1/02, H05K 3/00

(54) **OPTOELEKTRONISCHE BAUGRUPPE UND VERFAHREN ZUM HERSTELLEN EINER OPTOELEKTRONISCHEN BAUGRUPPE**
OPTOELECTRONIC MODULE AND MANUFACTURING PROCESS OF AN OPTOELECTRONIC MODULE
MODULE OPTOÉLECTRONIQUE ET PROCÉDÉ DE MANUFACTURE D'UN MODULE OPTOÉLECTRONIQUE

(30) Priorität: 24.03.2015 DE 102015205354
(43) Veröffentlichungstag der Anmeldung: 31.01.2018
(73) Patentinhaber: LEDVANCE GmbH, 85748 Garching (DE)
(72) Erfinder: ROSENBAUER, Georg, 91717 Wassertrüdingen (DE)
(74) Vertreter: Nordmeyer, Philipp Werner
(86) Internationale Anmeldenummer: PCT/EP2016/056147
(87) Internationale Veröffentlichungsnummer: WO 2016/150913

(56) Entgegenhaltungen:
- EP-A1- 1 463 391
- EP-A1- 2 365 539
- DE-A1-102012 219 879
- DE-B3-102013 211 977
- FR-A1- 2 862 424
- US-A1- 2003 116 547

## Beschreibung

Die Erfindung betrifft eine optoelektronische Baugruppe und ein Verfahren zum Herstellen einer optoelektronischen Baugruppe.

Eine herkömmliche optoelektronische Baugruppe weist mindestens ein optoelektronisches Bauelement auf, das auf einer Leiterplatte angeordnet ist. Das optoelektronische Bauelement kann beispielsweise eine Leuchtdiode (LED), eine organische Leuchtdiode (OLED) oder eine Solarzelle sein. Die Leiterplatte ist auf einer von dem optoelektronischen Bauelement abgewandten Seite der Leiterplatte auf einer Wärmesenke angeordnet. Die Leiterplatte ist mittels eines Verbindungselements an der Wärmesenke befestigt, beispielsweise mittels einer Schraube und/oder eines Klebers, beispielsweise eines Wärmeleitklebers.

Die Materialkosten für den Kleber und die Prozesskosten für und die Verwendung des Klebers sind relativ hoch. Insbesondere sind das Aufbringen und das Dosieren des Klebers aufwendig und die dafür benötigten Maschinen sind teuer. Stoffe in dem Kleber können sich mit der Zeit absetzen, so dass der Kleber vor dem Aufbringen gemischt werden muss oder erneuert werden muss. Düsen zum Aufbringen und/oder Dosieren des Klebers können mit der Zeit verstopfen und müssen dann ausgetauscht oder gereinigt werden. Bei dem auf das Aufbringen des Klebers folgenden Ausheizen des Klebers werden regelmäßig Temperaturen über 100°C benötigt, die für eine Stunde lang aufrechterhalten werden müssen. Dies bringt hohe Energiekosten mit sich und es besteht ein großer Platzbedarf für die benötigten Öfen. Des Weiteren muss darauf geachtet werden, dass der Kleber mit angrenzenden Polymeren chemisch verträglich ist, beispielsweise mit der Optik oder dem Gehäuse des optoelektronischen Bauelements. Außerdem weist selbst ein relativ guter Wärmeleitkleber verglichen mit einer Metallkernplatine oder einer Wärmesenke häufig eine geringe Wärmeleitfähigkeit auf. Beispielsweise kann die Wärmeleitfähigkeit eines guten Wärmeleitklebers kleiner als 10 W/mK sein, beispielsweise 2 W/mK, wohingegen eine Aluminiumlegierung, beispielsweise einer Wärmesenke oder einer Leiterplatte, eine Wärmeleitfähigkeit von größer 150 W/mK hat. Der Wärmeleitkleber ist anschaulich gesprochen somit meist ein thermisches Nadelöhr. Nicht zuletzt fallen beim Verwenden von Kleber zum Verbinden der Leiterplatte mit der Wärmesenke relativ hohe logistische Kosten an, da geeignete Kleber transportiert und häufig gekühlt werden müssen.

Bei der Befestigung mittels Schrauben fallen ebenfalls hohe Prozesskosten an, da Löcher gebohrt und Gewinde geschnitten werden müssen, beispielsweise in der Leiterplatte und/oder der Wärmesenke, wobei die Löcher und Gewinde zusätzlich zu den optoelektronischen Bauelementen einen gewissen Platzbedarf auf der Platine haben, weshalb eine relativ große Platine und/oder Wärmesenke nötig sind. Des Weiteren sind Schraubverbindungen sehr empfindlich bei einer erhöhten Oberflächenrauigkeit der Leiterplatte und/oder der Wärmesenke, da dann nur punktuelle Auflageflächen im Kontaktbereich zwischen Leiterplatte und Wärmesenke zustande kommen, die eine relativ geringe Wärmeübertragung ermöglichen.

DE 10 2012 219 879 A1 zeigt eine optoelektronische Baugruppe, bei der ein Kühlkörpermetall an eine MCPCB mittels Laser-Durchstrahlschweißung verbunden wird. Hierbei wird mittels des Lasers von unten, also von einer von dem optoelektronischen Bauelement abgewandten Seite des Kühlkörpermetalls, auf das Kühlkörpermetall gestrahlt und die komplette Wärmesenke durchschweißt, sowie zusätzlich ein Teil der MCPCB lokal aufgeschmolzen. Bei dem Laserschweißen bildet sich ein sogenanntes keyhole aus, das zu einer sehr engen, aber tiefen Schweißnaht führt. Bei dem Laserschweißen verbinden sich die beiden schmelzflüssigen Materialien der Wärmesenke und der Leiterplatte in der Schweißnaht, was einen guten Wärmeübergang ermöglicht.

FR 2 862 424 A1 zeigt eine optoelektronische Baugruppe aus dem Stand der Technik.

Eine Aufgabe der Erfindung ist es, eine optoelektronische Baugruppe bereitzustellen, bei der auf einfache und/oder effektive Art und Weise die Wärmeübertragung weiter verbessert ist, insbesondere ohne Verwendung eines Haftvermittlers, beispielsweise eines Lotes oder eines Klebers, insbesondere eines Wärmeleitklebers.

Eine Aufgabe der Erfindung ist es, ein Verfahren zum Herstellen einer optoelektronische Baugruppe bereitzustellen, das einfach und/oder kostengünstig durchführbar ist und/oder das dazu beiträgt, dass bei der optoelektronischen Baugruppe auf einfache und/oder effektive Art und Weise die Wärmeableitung weg von einem optoelektronischen Bauelement der optoelektronischen Baugruppe weiter verbessert ist, insbesondere ohne Verwendung eines Haftvermittlers, beispielsweise eines Lotes oder eines Klebers, insbesondere eines Wärmeleitklebers.

Eine Aufgabe wird gemäß dem unabhängigen Anspruch 1 gelöst durch eine optoelektronische Baugruppe, mit einer Leiterplatte, mindestens einem optoelektronischen ersten Bauelement, das auf einer ersten Seite der Leiterplatte angeordnet ist, einer Wärmesenke, die eine erste Oberfläche aufweist und die mit ihrer ersten Oberfläche an einer von dem ersten Bauelement abgewandten zweiten Seite der Leiterplatte angeordnet ist, wobei sich zwischen der zweiten Seite und der ersten Oberfläche eine Grenzfläche erstreckt, und mindestens einer ersten Schweißverbindung, mittels der die Wärmesenke unmittelbar und stoffschlüssig mit der Leiterplatte verbunden ist und die eine erste Schnittfläche mit der Grenzfläche bildet, wobei das erste Bauelement die Schnittfläche zumindest teilweise überlappt, wobei das erste Bauelement mittels einer Lötverbindung oder einer zweiten Schweißverbindung an der Leiterplatte befestigt ist, und wobei die Lötverbindung oder die zweite Schweißverbindung beim Ausbilden der ersten Schweißverbindung mittels eines Laserstrahls aufgeschmolzen worden ist, um das erste Bauelement stoffschlüssig mit der Leiterplatte zu verbinden.

Dass das erste Bauelement die erste Schnittfläche zumindest teilweise überlappt, bedeutet, dass bei einer Anordnung der optoelektronischen Baugruppe derart, dass sich die Leiterplatte und die Wärmesenke in einer horizontalen Ebene erstrecken, in einer Draufsicht auf die optoelektronische Baugruppe das erste Bauelement zumindest teilweise über der ersten Schnittfläche angeordnet ist. Anschaulich gesprochen sind die erste Schweißverbindung und insbesondere die erste Schnittfläche direkt hinter dem ersten Bauelement angeordnet.

Ferner können die erste Schnittfläche und eine aktive Schicht des ersten Bauelements zumindest teilweise überlappen. Eine aktive Schicht des ersten Bauelements kann dabei der Bereich des Bauelements sein, in dem durch die Rekombination von Ladungsträgern elektromagnetische Strahlung erzeugt wird. Zum Beispiel kann die aktive Schicht bei einer Leuchtdiode Teil einer epitaktisch aufgebrachten Schichtenfolge sein. Die aktive Schicht kann sich dabei in einer horizontalen Ebene erstrecken, die im Wesentlichen parallel zur Leiterplatte angeordnet ist.

Die Grenzfläche ist keine reale Fläche, sondern lediglich eine imaginäre Fläche, die zur Definition der ersten Schnittfläche dient. Die Grenzfläche kann vor dem Ausbilden der ersten Schweißverbindung beispielsweise zu der zweiten Seite der Leiterplatte oder zu der ersten Oberfläche der Wärmesenke korrespondieren oder zumindest parallel zu diesen verlaufen. Beim Ausbilden der ersten Schweißverbindung verschmelzen jedoch die Materialien der zweiten Seite der Leiterplatte und der ersten Oberfläche der Wärmesenke, so dass diese nach dem Ausbilden der ersten Schweißverbindung im Bereich der ersten Schweißverbindung nicht mehr wohldefiniert sind, weshalb nach dem Ausbilden der ersten Schweißverbindung die Grenzfläche ein Hilfskonstrukt ist, um die Position der ersten Schnittfläche mit Bezug zu dem ersten Bauelement präzise definieren zu können. Falls die zweite Seite der Leiterplatte und/oder die erste Oberfläche der Wärmesenke plan ausgebildet sind, so liegt die erste Grenzfläche in einer Ebene und/oder kann als Grenzebene bezeichnet werden. Falls die zweite Seite der Leiterplatte und die erste Oberfläche der Wärmesenke gekrümmt ausgebildet sind, so ist die Grenzfläche dazu korrespondierend gekrümmt. Falls die zweite Seite der Leiterplatte und die erste Oberfläche der Wärmesenke einen Knick aufweisen, so weist die Grenzfläche einen dazu korrespondierenden Knick auf.

Die Platzierung der unmittelbaren und stoffschlüssigen ersten Schweißverbindung in Bezug auf das im Betrieb wärmeerzeugende erste Bauelement, beispielsweise eine LED oder eine OLED, bewirkt eine besonders gute Wärmeableitung von dem ersten Bauelement über die Leiterplatte zu der Wärmesenke. Die besonders gute Wärmeableitung ist in einem erhöhten Anpressdruck der Leiterplatte auf die Wärmesenke direkt unter dem ersten Bauelement begründet. In anderen Worten bewirkt eine hohe Anpresskraft zwischen Leiterplatte und Wärmesenke direkt hinter dem ersten Bauelement einen geringen thermischen Widerstand beim Übergang von der Leiterplatte zu der Wärmesenke in diesem Bereich.

Der erhöhte Anpressdruck bzw. die erhöhte Anpresskraft werden durch Schrumpfspannungen hervorgerufen, die beim Herstellen der ersten Schweißverbindung entstehen. Insbesondere werden beim Abkühlen des schmelzflüssigen Materials in der Schweißzone die Leiterplatte und die Wärmesenke zueinander hingezogen, was eine sehr hohe Flächenpressung direkt hinter dem ersten Bauelement und damit einen geringen thermischen Widerstand und eine gute Wärmeableitung weg von dem ersten Bauelement bewirkt. Des Weiteren bewirkt die hohe Flächenpressung eine Deformation von Rauhigkeitsspitzen der Leiterplatte und/oder der Wärmesenke und damit eine größere Kontaktfläche zwischen Leiterplatte und Wärmesenke wodurch die Wärmeleitfähigkeit und die Wärmeableitung weiter verbessert sind, insbesondere direkt hinter bzw. unter dem ersten Bauelement. Außerdem sind nach dem Schweißen an der Oberfläche der Schweißnaht der Schweißverbindungsstelle häufig Aufwölbungen der verschweißten Materialien zu finden, die während des Schweißen von schmelzflüssigem Material gebildet werden und die im Inneren der Schweißnaht eine Art Materialverlust darstellen, wodurch neben der reinen Materialkontraktion der Schweißmaterialien zusätzlich starke Schrumpfspannungen erzeugt werden, wodurch der Anpressdruck bzw. die Anpresskraft besonders hoch sind. Ferner gilt, je größer die aufgrund des Schweißvorgangs verschmolzene Fläche ist, desto größer sind die erzeugten Eigenspannungen und/oder Flächenpressung und desto besser ist der Wärmeübergang.

Somit ist das Herstellen der ersten Schweißverbindung verbunden mit der Erzeugung von Schrumpfspannungen, die eine erhöhte Flächenpressung im Kontaktbereich zwischen der Leiterplatte und der Wärmesenke direkt hinter dem ersten Bauelement hervorrufen, was wiederum eine besonders gute Wärmeableitung direkt hinter dem ersten optoelektronischen Bauelement ermöglicht. Somit kann die von dem optoelektronischen ersten Bauelement erzeugte Wärme besonders gut von der Leiterplatte hin zu der Wärmesenke abfließen. Dies ermöglicht, das erste Bauelement mit besonders hoher Leistung und/oder besonders lang betreiben zu können, ohne dass dieses beschädigt wird.

Das erste Bauelement ist mittels einer Lötverbindung oder einer Schweißverbindung an der Leiterplatte befestigt, wobei die erste Schweißverbindung, insbesondere die Laserschweißnaht, direkt hinter dem ersten Bauelement zusätzlich dazu beiträgt, dass die Löt- bzw. Schweißverbindung zwischen dem ersten Bauelement und der Leiterplatte bzgl. mechanischer Festigkeit und Thermowechselbeanspruchung besonders stabil ist. Ursache hierfür ist das nochmalige Aufschmelzen und Abkühlen der Lot- bzw. Schweißverbindung bei vorgegebener Laserleistung und Einschweißtiefe. Durch das schnelle Abschrecken beim Laserprozess aufgrund sehr hoher Kühlraten bei punktueller Lasererwärmung wird ein sehr feinkörniges Gefüge in der Lot- bzw. Schweißverbindung eingestellt, was für die mechanische Festigkeit sowie die Temperaturwechselbeanspruchung bei Temperaturschocktests besonders gut ist.

Des Weiteren fallen keine Materialkosten für Kleber oder Schrauben an, ein Ausheizen ist nicht notwendig, der Prozess ist schnell und berührungslos durchführbar und automatisierbar, der Wärmeübergang ist in der Regel besser als beim Kleben und/oder Schrauben, es besteht kein Platzbedarf auf der MCPCB für Bohrungslöcher für Schrauben und es besteht eine hohe mechanische Festigkeit und eine hohe Temperaturwechselfestigkeit bzgl. Thermoschock-Beanspruchung. Ein Lösen der Verschraubung oder Alterungseffekte wie beim Kleber gibt es nicht.

Bei einer Weiterbildung überlappt das erste Bauelement die erste Schnittfläche vollständig. In anderen Worten liegt bei einer horizontalen Ausrichtung der Leiterplatte die erste Schnittfläche in Draufsicht vollständig hinter dem ersten Bauelement. Dies kann zu einem besonders hohen Wärmeleitkoeffizienten direkt hinter dem ersten Bauelement und damit zu einer besonders guten Wärmeableitung weg von dem ersten Bauelement beitragen.

Bei einer Weiterbildung erstreckt sich die erste Schweißverbindung durch die gesamte Dicke der Wärmesenke hindurch. Dies kann dazu beitragen, dass die erste Schweißverbindung besonders einfach herstellbar ist.

Bei einer Weiterbildung ist die erste Schweißverbindung in Richtung parallel zu der Grenzfläche linienförmig, insbesondere geradlinig, polygonal, kreisförmig und/oder mäanderförmig ausgebildet. Bei Versuchen mit unterschiedlichen Geometrien der ersten Schweißverbindung hat sich gezeigt, dass zusätzlich zur stoffschlüssigen Schweißverbindung direkt hinter dem ersten Bauelement gezielt der Anpressdruck bzw. die Anpresskraft zwischen der Leiterplatte und der Wärmesenke mittels einer geeigneten Geometrie der ersten Schweißverbindung, insbesondere der entsprechenden Laserschweißnaht, erzeugt werden kann. Insbesondere haben die Versuche gezeigt, dass durch eine in lateraler Richtung linienförmige, eine geschlossene Fläche umschließende, polygonale, kreisförmige und/oder mäanderförmige Schweißnaht besonders hohe Schrumpfspannungen und infolgedessen Anpressdrücke erzeugt werden, was einen besonders hohen Wärmeleitkoeffizienten und eine besonders gute Wärmeableitung bewirkt. Dabei können die genannten Geometrien auch miteinander kombiniert werden, beispielsweise kann die erste Schweißverbindung so ausgebildet werden, dass sie linienförmig und mäanderförmig verläuft, wodurch eine Schweißraupe erzeugt wird. Die Schweißraupe kann dann so ausgebildet werden, dass sie eine geschlossene Fläche umschließt, beispielsweise eine polygonale oder kreisförmige, wodurch die Schrumpfspannungen, der Anpressdruck und die Anpresskraft weiter erhöht und die thermische Leitfähigkeit weiter verbessert werden.

Bei einer Weiterbildung ist die erste Schweißverbindung kreisförmig ausgebildet und es ist mindestens eine zweite Schweißverbindung ausgebildet, mittels der die Wärmesenke unmittelbar und stoffschlüssig mit der Leiterplatte verbunden ist und die konzentrisch zu der ersten Schweißverbindung ausgebildet ist. Die zweite Schweißverbindung bildet eine zweite Schnittfläche mit der Grenzfläche. Die zweite Schweißverbindung kann ebenfalls kreisförmig ausgebildet sein. Die zweite Schweißverbindung kann so ausgebildet sein, dass das erste Bauelement die zweite Schnittfläche zumindest teilweise überlappt. Beispielsweise kann die zweite Schweißverbindung derart ausgebildet sein, dass das erste Bauelement die zweite Schnittfläche vollständig überlappt. Alternativ dazu können die erste und/oder die zweite Schweißverbindung derart ausgebildet sein, dass das erste Bauelement und ein, zwei oder drei weitere Bauelemente die erste und/oder die zweite Schnittfläche zumindest teilweise überlappen. Beispielsweise können die entsprechenden Bauelemente einzelne Segmente der Schweißverbindungen überlappen. Das bezüglich der ersten Schweißverbindung konzentrische Ausbilden der zweiten Schweißverbindung bewirkt besonders hohe Schrumpfspannungen und Anpressdrücke und damit eine besonders gute Wärmeableitung direkt hinter dem Bauelement.

Bei einer Weiterbildung ist die erste Schweißverbindung geradlinig ausgebildet und es ist mindestens eine zweite Schweißverbindung ausgebildet, mittels der die Wärmesenke unmittelbar und stoffschlüssig mit der Leiterplatte verbunden ist, die eine zweite Schnittfläche mit der Grenzfläche bildet und die parallel zu der ersten Schweißverbindung ausgebildet ist. Die zweite Schweißverbindung kann ebenfalls geradlinig ausgebildet sein. Die zweite Schweißverbindung kann so ausgebildet sein, dass das erste Bauelement die zweite Schnittfläche zumindest teilweise überlappt. Beispielsweise können die erste und/oder die zweite Schweißverbindung derart ausgebildet sein, dass das erste Bauelement und ein, zwei oder drei weitere Bauelemente Abschnitte der ersten und/oder zweiten Schnittfläche zumindest teilweise überlappen. Beispielsweise können die entsprechenden Bauelemente matrixförmig in Zeilen und Spalten angeordnet sein und die Schweißverbindungen können entlang der Zeilen und/oder Spalten ausgebildet sein. Das parallele, spalten- und/oder zeilenförmige Ausbilden der Schweißverbindungen bewirkt besonders hohe Schrumpfspannungen und Anpressdrücke und damit eine besonders gute Wärmeableitung.

Bei einer Weiterbildung weist die optoelektronische Baugruppe mindestens ein optoelektronisches zweites Bauelement auf, beispielsweise das im Vorhergehenden genannte zweite Bauelement, das auf der ersten Seite der Leiterplatte angeordnet ist und das die erste Schnittfläche und/oder die zweite Schnittfläche zumindest teilweise überlappt. Dass das zweite Bauelement derart angeordnet ist, dass es die erste und/oder die zweite Schnittfläche zumindest teilweise überlappt, bewirkt, dass auch die Wärmeableitung weg von dem zweiten Bauelement besonders gut ist.

Bei einer Weiterbildung ragen die erste Schweißverbindung und/oder die zweite Schweißverbindung mit einer Tiefe in die Leiterplatte hinein, die 5% bis 50% der Dicke der Leiterplatte entspricht. Beispielsweise kann die Tiefe 20% der Dicke der Leiterplatte entsprechen. Dies kann dazu beitragen, dass einerseits die mechanische Festigkeit der Schweißverbindungen besonders gut ist und dennoch beim Herstellen der Schweißverbindungen das bzw. die Bauelemente nicht zu stark erhitzt werden.

Eine Aufgabe wird gemäß dem unabhängigen Anspruch 10 gelöst durch ein Verfahren zum Herstellen einer optoelektronischen Baugruppe gelöst, bei dem die Leiterplatte bereitgestellt wird, mindestens das optoelektronische erste Bauelement auf der ersten Seite der Leiterplatte angeordnet wird, an der von der ersten Seite abgewandten zweiten Seite der Leiterplatte die erste Oberfläche der Wärmesenke angeordnet wird, wobei sich zwischen der zweiten Seite und der ersten Oberfläche die Grenzfläche erstreckt, und die Leiterplatte mittels mindestens der ersten Schweißverbindung unmittelbar und stoffschlüssig mit der Wärmesenke verbunden wird, wobei die erste Schweißverbindung mittels eines Laserstrahls, der von außen auf eine von der Leiterplatte abgewandte zweite Oberfläche der Wärmesenke gestrahlt wird, so ausgebildet wird, dass die erste Schweißverbindung die erste Schnittfläche mit der Grenzfläche bildet und dass das erste Bauelement die erste Schnittfläche zumindest teilweise überlappt, und wobei gleichzeitig zu dem Ausbilden der ersten Schweißverbindung mittels desselben Laserstrahls, mit dem die erste Schweißverbindung ausgebildet wird, das erste Bauelement stoffschlüssig mit der Leiterplatte verbunden wird.

Die im Vorhergehenden im Zusammenhang mit der optoelektronischen Baugruppe genannten Vorteile können ohne weiteres auf das Verfahren zum Herstellen der optoelektronischen Baugruppe übertragen werden. Außerdem kann das Herstellen der ersten Schweißverbindung mittels des Laserstrahls besonders schnell, einfach, präzise und/oder kostengünstig durchgeführt werden.

Bei einer Weiterbildung werden die Wärmesenke und/oder die Leiterplatte während des Ausbildens der ersten Schweißverbindung gekühlt. Die Kühlung kann beispielsweise mittels eines Kühlgases, mittels Luftkühlung, beispielsweise mittels Anblasens der Leiterplatte und/oder der Wärmesenke und/oder mittels körperlichen Kontakts zu einem Kühlelement erfolgen. Die Kühlung kann dazu beitragen, dass das erste Bauelement und/oder die Leiterplatte beim Herstellen der ersten Schweißverbindung nicht überhitzen und beschädigt werden. Dadurch kann das Laserprozessfenster hinsichtlich verschweißter und danach unter Schrumpfspannung stehender Fläche deutlich vergrößert werden.

Bei einer Weiterbildung wird Schmauch, der bei dem Ausbilden der ersten Schweißverbindung entsteht, während des Ausbildens der ersten Schweißverbindung abgesaugt. Dies kann dazu beitragen, dass die optoelektronische Baugruppe beim Herstellen der ersten Schweißverbindung nicht verschmutzt wird.

Bei einer Weiterbildung wird mindestens die zweite Schweißverbindung ausgebildet, mittels der die Leiterplatte an deren zweiten Seite mit der ersten Oberfläche der Wärmesenke unmittelbar und stoffschlüssig verbunden wird, wobei die zweite Schweißverbindung mittels eines Laserstrahls, der von außen auf die zweite Oberfläche der Wärmesenke gestrahlt wird, ausgebildet wird. Der Laserstrahl kann derselbe oder ein anderer Laserstrahl sein wie der Laserstrahl, der zum Ausbilden der ersten Schweißverbindung verwendet wird.

Bei dem Verfahren wird gleichzeitig zu dem Ausbilden der ersten Schweißverbindung mittels desselben Laserstrahls, mit dem die erste Schweißverbindung ausgebildet wird, das erste Bauelement stoffschlüssig mit der Leiterplatte verbunden. Die stoffschlüssige Verbindung zwischen dem ersten Bauelement und der Leiterplatte kann beispielsweise eine Lötverbindung oder eine Schweißverbindung sein. In anderen Worten kann mittels des Laserstrahls die Leiterplatte derart erhitzt werden, dass die stoffschlüssige Verbindung zu dem ersten Bauelement entsteht. Beispielsweise kann zwischen dem ersten Bauelement und der Leiterplatte Lot angeordnet sein, welches beim Herstellen der ersten Schweißverbindung schmilzt und beim nachfolgenden Abkühlen die Leiterplatte stoffschlüssig mit dem ersten Bauelement verbindet. Dies ermöglicht, zwei Arbeitsschritte, insbesondere das Verbinden des ersten Bauelements mit der Leiterplatte und das Verbinden der Leiterplatte mit der Wärmesenke in einem Arbeitsschritt durchzuführen. Dies kann dazu beitragen, dass die Prozesszeit besonders kurz ist und die Prozesskosten besonders gering sind.

Ausführungsbeispiele der Erfindung sind in den Figuren dargestellt und werden im Folgenden näher erläutert.

Es zeigen:
- Figur 1: eine Schnittdarstellung eines Ausführungsbeispiels einer optoelektronischen Baugruppe;
- Figur 2: eine Draufsicht auf die optoelektronische Baugruppe gemäß Figur 1;
- Figur 3: eine Schnittdarstellung eines Ausführungsbeispiels einer optoelektronischen Baugruppe;
- Figur 4: eine Draufsicht auf die optoelektronische Baugruppe gemäß Figur 3;
- Figur 5: eine Schnittdarstellung eines Ausführungsbeispiels einer optoelektronischen Baugruppe;
- Figur 6: eine Draufsicht auf die optoelektronische Baugruppe gemäß Figur 5;
- Figur 7: eine Schnittdarstellung eines Ausführungsbeispiels einer optoelektronischen Baugruppe;
- Figur 8: eine Draufsicht auf die optoelektronische Baugruppe gemäß Figur 7;
- Figur 9: eine Schnittdarstellung eines Ausführungsbeispiels einer optoelektronischen Baugruppe;
- Figur 10: eine Draufsicht auf die optoelektronische Baugruppe gemäß Figur 9;
- Figur 11: eine Schnittdarstellung eines Ausführungsbeispiels einer optoelektronischen Baugruppe;
- Figur 12: eine Draufsicht auf die optoelektronische Baugruppe gemäß Figur 11;
- Figur 13: eine Schnittdarstellung eines Ausführungsbeispiels einer optoelektronischen Baugruppe beim Herstellen einer Schweißverbindung;
- Figur 14: eine Schnittdarstellung eines Ausführungsbeispiels einer optoelektronischen Baugruppe nach dem Herstellen einer Schweißverbindung;
- Figur 15: ein Ablaufdiagramm eines Ausführungsbeispiels eines Verfahrens zum Herstellen einer optoelektronischen Baugruppe,
- Figur 16: eine Schnittdarstellung eines Ausführungsbeispiels einer optoelektronischen Baugruppe beim Herstellen einer stoffschlüssigen Verbindung;
- Figur 17: ein Ablaufdiagramm eines Ausführungsbeispiels eines Verfahrens zum Herstellen einer optoelektronischen Baugruppe
- Figur 18: ein Diagramm mit ersten Messergebnissen;
- Figur 19: ein Diagramm mit zweiten Messergebnissen;
- Figur 20: eine Schnittdarstellung eines Ausführungsbeispiels einer optoelektronischen Baugruppe.

In der folgenden ausführlichen Beschreibung wird auf die beigefügten Zeichnungen Bezug genommen, die Teil dieser Beschreibung bilden und in denen zur Veranschaulichung spezifische Ausführungsbeispiele gezeigt sind, in denen die Erfindung ausgeübt werden kann. Da Komponenten von Ausführungsbeispielen in einer Anzahl verschiedener Orientierungen positioniert werden können, dient die Richtungsterminologie zur Veranschaulichung und ist auf keinerlei Weise einschränkend. Es versteht sich, dass andere Ausführungsbeispiele benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen Ausführungsbeispiele miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert. In den Figuren sind identische oder ähnliche Elemente mit identischen Bezugszeichen versehen, soweit dies zweckmäßig ist.

Eine optoelektronische Baugruppe kann ein, zwei oder mehr optoelektronische Bauelemente aufweisen. Optional kann eine optoelektronische Baugruppe auch ein, zwei oder mehr elektronische Bauelemente aufweisen. Ein elektronisches Bauelement kann beispielsweise ein aktives und/oder ein passives Bauelement aufweisen. Ein aktives elektronisches Bauelement kann beispielsweise eine Rechen-, Steuer- und/oder Regeleinheit und/oder einen Transistor aufweisen. Ein passives elektronisches Bauelement kann beispielsweise einen Kondensator, einen Widerstand, eine Diode oder eine Spule aufweisen.

Ein optoelektronisches Bauelement kann ein elektromagnetische Strahlung emittierendes Bauelement oder ein elektromagnetische Strahlung absorbierendes Bauelement sein. Ein elektromagnetische Strahlung absorbierendes Bauelement kann beispielsweise eine Solarzelle sein. Ein elektromagnetische Strahlung emittierendes Bauelement kann in verschiedenen Ausführungsbeispielen ein elektromagnetische Strahlung emittierendes Halbleiter-Bauelement sein und/oder als eine elektromagnetische Strahlung emittierende Diode, als eine organische elektromagnetische Strahlung emittierende Diode, als ein elektromagnetische Strahlung emittierender Transistor oder als ein organischer elektromagnetische Strahlung emittierender Transistor ausgebildet sein. Die Strahlung kann beispielsweise Licht im sichtbaren Bereich, UV-Licht und/oder Infrarot-Licht sein. In diesem Zusammenhang kann das elektromagnetische Strahlung emittierende Bauelement beispielsweise als Licht emittierende Diode (light emitting diode, LED) als organische Licht emittierende Diode (organic light emitting diode, OLED), als Licht emittierender Transistor oder als organischer Licht emittierender Transistor ausgebildet sein. Das Licht emittierende Bauelement kann in verschiedenen Ausführungsbeispielen Teil einer integrierten Schaltung sein. Weiterhin kann eine Mehrzahl von Licht emittierenden Bauelementen vorgesehen sein, beispielsweise untergebracht in einem gemeinsamen Gehäuse.

Bei einer stoffschlüssigen Verbindung ist ein erster Körper mit einem zweiten Körper mittels atomarer und/oder molekularer Kräfte verbunden. Stoffschlüssige Schweißverbindungen sind sogenannte nicht lösbare Schweißverbindungen sein, die nicht ohne eine gewisse Beschädigung eines der beteiligten Körper lösbar sind. In verschiedenen Ausgestaltungen kann eine stoffschlüssige Verbindung beispielsweise eine Lotverbindung, beispielsweise eines Glaslotes oder eines Metalllotes, oder eine Schweißverbindung sein.

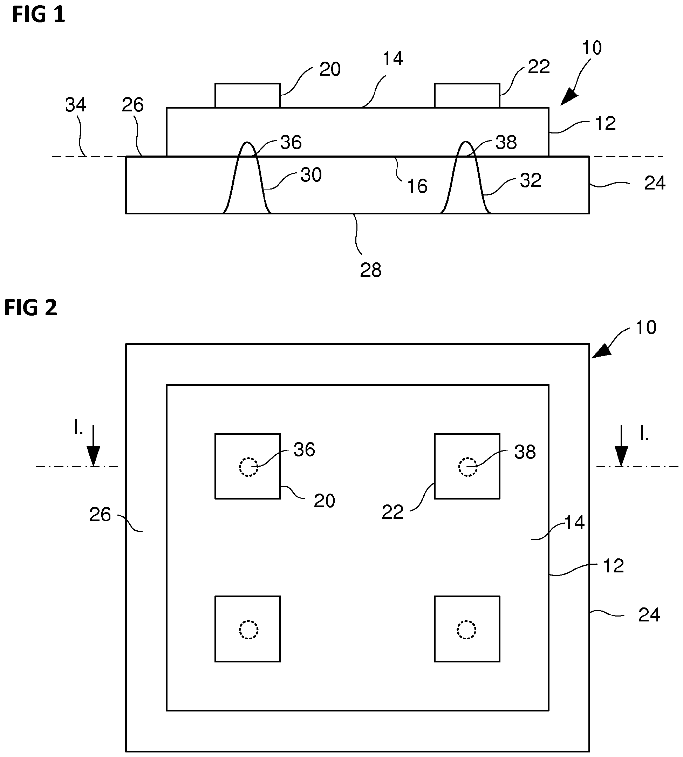

**Fig. 1** zeigt eine Schnittdarstellung eines Ausführungsbeispiels einer optoelektronischen Baugruppe 10. Die optoelektronische Baugruppe 10 weist eine Leiterplatte 12 auf. Die Leiterplatte 12 hat eine erste Seite 14 und eine von der ersten Seite 14 abgewandte zweite Seite 16. Die optoelektronische Baugruppe 10 weist mindestens ein optoelektronisches erstes Bauelement 20 und ein optoelektronisches zweites Bauelement 22 auf. Die Bauelemente 20, 22 sind auf der ersten Seite 14 der Leiterplatte 12 angeordnet. Die Bauelemente 20, 22 sind mittels Lötverbindungen oder Schweißverbindungen mit der Leiterplatte 12 verbunden. Die Bauelemente 20, 22 sind insbesondere im Kunststoffgehäuse vergossene LEDs, LEDs ohne Kunststoffgehäuse, Chip on Bord (CoB) bzw. Chips Scale Package (CSP) LEDs, LED Multichip Arrays und/oder LEDs mit extremen Ausstrahlspektrum (z.B. Laserdioden). Die optoelektronische Baugruppe 10 kann beispielsweise als Leuchtmittel im Automotivebereich oder im Bereich der Allgemeinbeleuchtung verwendet werden.

Eine Wärmesenke 24 der optoelektronischen Baugruppe 10 weist eine erste Oberfläche 26 und eine von der ersten Oberfläche 26 abgewandte zweite Oberfläche 28 auf. Die Leiterplatte 12 ist mit ihrer zweiten Seite 16 an der ersten Oberfläche 26 der Wärmesenke 24 angeordnet. Die Leiterplatte 12 ist mit der Wärmesenke 24 mittels mindestens einer ersten Schweißverbindung 30 und einer zweiten Schweißverbindung 32 stoffschlüssig und unmittelbar verbunden. Zwischen der zweiten Seite 16 der Leiterplatte 12 und der ersten Oberfläche 26 der Wärmesenke 24 erstreckt sich eine im Grenzfläche 34. Die Grenzfläche 34 bildet mit der ersten Schweißverbindung 30 eine erste Schnittfläche 36 und mit der zweiten Schweißverbindung 32 eine zweite Schnittfläche 38. Die Schweißverbindungen 30, 32, die auch als Keyhols, bezeichnet werden können, durchdringen die komplette Wärmesenke 24 und zusätzlich ca. 5% bis 50%, beispielsweise ca. 20%, der Dicke der Leiterplatte 12.

Dass die Leiterplatte 12 unmittelbar mit der Wärmesenke 24 verbunden ist, bedeutet, dass kein Haftvermittler zwischen der Leiterplatte 12 und der Wärmesenke 24 angeordnet ist und dass die Leiterplatte 12 und die Wärmesenke 24 in direktem körperlichem Kontakt miteinander verbunden sind.

Die Leiterplatte 12 weist einen metallischen Träger auf, auf dem eine Isolationsschicht ausgebildet ist, auf der eine Kupferlage ausgebildet ist, mittels der Leiterbahnen gebildet sind. Die Leiterplatte 12 ist eine Metallkernplatine (Metalcore Printed Circuit Board - MCPCB), die einen Aluminium-, Kupfer- oder Stahlkern aufweist, auf dem ein Dielektrikum ausgebildet ist, das beispielsweise Epoxidharz, anodisiertes, d.h. oxidiertes, Aluminiumoxid oder Diamond Like Carbon (DLC) aufweist, wobei auf dem Dielektrikum Leiterbahnen, insbesondere Kupferleiterbahnen, ausgebildet sind, die zumindest teilweise mittels Lötstopplack versiegelt sind. Die Isolationsschicht, also das Dielektrikum, hat eine Wärmeleitfähigkeit beispielsweise von 0,2 W/mK bis 14 W/mK. Dabei ist durch den Einsatz von Füllstoffen in dem Dielektrikum dessen Wärmeleitfähigkeit um das 3- bis 45-fache höher, als die einer FR4-Leiterplatte. Dadurch ist eine sehr gute horizontale und vertikale Wärmeleitung gegeben. Die Kupferlage weist eine einfache, beispielsweise einlagige, Schaltung auf. Die Leiterplatte 12 kann beispielsweise 0,1 mm bis 5 mm, beispielsweise 0,5 mm bis 3 mm, beispielsweise ungefähr 2 mm dick sein. Der Träger weist Aluminium oder Kupfer auf und ist 0,5 mm bis 3 mm dick. Die Isolationsschicht ist 70 µm bis 100 µm dick. Die Kupferlage ist 18 µm bis 400 µm, beispielsweise 35 µm bis 400 µm, dick. Die Leiterplatte 12 kann alternativ dazu beispielsweise eine FR1-, FR2-, FR3-, FR4-, FR5-, CEM1-, CEM2-, CEM3-, CEM4- oder CEM5-Leiterplatte sein, beispielsweise eine durchkontaktierte FR4-Leiterplatte. Ferner kann ein umspritztes und/oder overmolded Leadframekonzept als Leiterplatte 12 oder ein reines Leadframekonzept und/oder Stanzgitterkonzept als Leiterplatte 12 verwendet werden.

Die Wärmesenke 24, die auch als Heatsink bezeichnet werden kann, kann beispielsweise ein metallisches Material, beispielsweise Aluminium, Kupfer, Stahl, Molybdän, Wolfram oder ein anderes sehr gut wärmeleitendes Material, wie beispielswiese eine geeignete Keramik oder ein gefülltes Polymer aufweisen oder daraus gebildet sein. Die Wärmesenke 24 kann beispielsweise 0,1 mm bis 0,5 mm, beispielsweise 0,2 mm bis 2 mm, beispielsweise ungefähr 1 mm dick sein.

Beispielsweise kann die Leiterplatte 12 an der zweiten Seite 16 Aluminium aufweisen und die Wärmesenke 24 kann an der ersten Oberfläche 26 Aluminium oder Kupfer aufweisen. Alternativ oder zusätzlich können an der zweiten Seite 16 und/oder der ersten Oberfläche 26 weiche Beschichtungen ausgebildet sein, beispielsweise können die Leiterplatte 12 und/oder die Wärmesenke 24 im Kern Edelstahl aufweisen, der mit Zinn beschichtet ist. Ferner kann die Wärmesenke 24 metallisch ausgebildet sein und mit einer metallisch beschichteten AlN-Keramik (submount), verschweißt sein, die beispielsweise im Autolampenscheinwerferbereich eingesetzt werden. Somit ist das Verschweißen von metallischen Wärmesenken 24, beispielsweise aus Al, Cu, WCu usw. mit metallisch beschichteten Keramischen Submount-LEDs, beispielsweise AlN mit Al, Sn, Cu, Pt, Pd, Au, Ag, Pd, Ni, Fe, etc. -Schichten möglich. Somit kann die Wärmesenke 24 auch mit einer metallisch beschichteten Keramik laserverschweißt sein.

Ferner kann alternativ zu Aluminium auch ein Material für die Wärmesenke 24 verwendet werden, das einen thermischen Ausdehnungskoeffizienten im Bereich der AlN-Keramik besitzt, beispielsweise Molybdän, Wolfram, Wolfram-Kupfer usw. Alternativ zu den oben genannten Materialpaarungen Al/Al und Al/Cu für die zweite Seite 16 und die erste Oberfläche 26 können beispielsweise auch Cu/Cu, Sn/Cu, Sn/Al, W/Mo, W/Cu, Mo/Cu, W/Cu , Al/Fe, Sn/Fe, Ni/Sn, Ni/Fe, Ni/Cu, Pt/Sn, Fe/Cu, AI/C, W/C oder Paarungen mit Ni/Pd/Au etc. verschweißt sein.

Falls auf der zweiten Seite 16 und/oder der ersten Oberfläche 26 eine Beschichtung, insbesondere eine weiche Beschichtung, vorgesehen ist, so kann diese beispielsweise eine mittels Mikro- oder Nanopulver hergestellte und/oder extrem dünne metallische Beschichtung zum Ausgleich der Rauhigkeitsspitzen sein, beispielsweise eine Bornitrid- oder Kohlenstoff-Beschichtung mit einer Wärmeleitfähigkeit von ca. 400 W/mK oder eine mit Silber-Nanopulver mit einer Wärmeleitfähigkeit größer als 400 W/mk, wobei die Schichtdicken im Größenordnungsbereich der Oberflächenrauigkeit liegen oder bevorzugt etwas größer sind und die Beschichtungen zumindest direkt hinter bzw. unter den Bauelementen 20, 22 ausgebildet sind. Dadurch können Kosten bei der Oberflächenbearbeitung der Kühlkörper eingespart werden. Außerdem kann die Wärmeleitfähigkeit weiter verbessert werden, indem zwischen die aufgrund der Schweißverbindungen vorgespannten Materialien besonders gut wärmeleitfähige Beschichtungen und/oder Wärmeleitpasten/-pulver aufgebracht sind. Insbesondere können bei Anwendungen mit extremen Anforderungen bezüglich der Wärmeleitung wie, z.B. bei einer Kupfer-Leiterplatte, hinter den Bauelementen Beschichtungen mit Kohlenstoff-Nanoröhren, oder Diamant- oder DLC Nanopulver/Nanopasten mit einer typischen Wärmeleitfähigkeit von 360 bis 1000 W/mK eingesetzt werden.

Die Grenzfläche 34 ist keine reale Fläche der optoelektronischen Baugruppe 10, sondern lediglich eine imaginäre Fläche, die zur Definition der ersten Schnittfläche 36 und gegebenenfalls weiteren Schnittflächen und damit zur Definition der Ausbildung und Position der ersten Schweißverbindung 30 und gegebenenfalls weiteren Schweißverbindungen dient. Die Grenzfläche 34 kann vor dem Ausbilden der ersten Schweißverbindung 30 beispielsweise zu der zweiten Seite 16 der Leiterplatte 12 oder zu der ersten Oberfläche 26 der Wärmesenke 24 korrespondieren oder zumindest parallel zu diesen verlaufen. Beim Ausbilden der ersten Schweißverbindung 30 verschmelzen jedoch die Materialien der zweiten Seite 16 der Leiterplatte 12 und der ersten Oberfläche 26 der Wärmesenke 24, so dass diese nach dem Ausbilden der ersten Schweißverbindung 30 im Bereich der ersten Schweißverbindung 30 nicht mehr wohldefiniert sind, weshalb nach dem Ausbilden der ersten Schweißverbindung 30 die Grenzfläche 34 ein Hilfskonstrukt ist, um die Position der ersten Schnittfläche 36 mit Bezug zu dem ersten Bauelement 20 präzise definieren zu können. Die zweite Seite 16 der Leiterplatte 12 und die erste Oberfläche 26 der Wärmesenke 24 sind plan ausgebildet, daher liegt die Grenzfläche 34 in einer Ebene und kann als Grenzebene bezeichnet werden. Falls bei einer alternativen Ausführungsform die zweite Seite 16 der Leiterplatte 12 und die erste Oberfläche 26 der Wärmesenke 24 gekrümmt ausgebildet sind, so ist die Grenzfläche 34 dazu korrespondierend gekrümmt.

**Fig. 2** zeigt eine Draufsicht auf die optoelektronische Baugruppe 10 gemäß Figur 1. Zusätzlich zu dem ersten und zweiten Bauelemente 20, 22 sind zwei weitere optoelektronische Bauelemente 20, 22 angeordnet. Alternativ dazu können jedoch auch lediglich ein, zwei oder mehr als vier optoelektronische Bauelemente 20, 22 angeordnet sein. Die optoelektronischen Bauelemente 20, 22 überlappen jeweils eine der Schweißverbindungen 30, 32 zumindest teilweise, insbesondere vollständig. Die optoelektronischen Bauelemente 20, 22 und die entsprechenden Schweißverbindungen 30, 32 sind in den Ecken eines Rechtecks angeordnet. Alternativ dazu können die Bauelemente 20, 22 jedoch auch an den Ecken eines Dreiecks oder einer anderen polygonalen Form oder entlang einer Linie, einer Kreisform, beispielsweise entlang eines Kreises oder einer Ellipse, angeordnet sein. Jedem Bauelement 20, 22 ist eine der Schweißverbindungen 30, 32 zugeordnet, die in Draufsicht direkt unter bzw. hinter dem entsprechenden Bauelement 20, 22 angeordnet ist. Zusätzlich können zu einem oder mehreren der Bauelemente 20, 22 ein, zwei oder drei weitere Schweißverbindungen 30, 32 ausgebildet sein.

Die erste und die zweite Schweißverbindung 30, 32 können gleichzeitig oder nacheinander ausgebildet werden. Beispielsweise kann die zweite Schweißverbindung 32 eine vorgegebene Zeitdauer nach der ersten Schweißverbindung 30 ausgebildet werden. Während der vorgegebenen Zeitdauer kann die optoelektronische Baugruppe 10 gekühlt werden.

Bei dem in Fig. 2 dargestellten Ausführungsbeispiel sind die erste und zweite Schnittfläche 36, 38 im Wesentlichen zentral unter den optoelektronischen Bauelementen 20, 22 angeordnet. Die erste und zweite Schnittfläche 36, 38 sind dabei unter einer Lichtaustrittfläche beziehungsweise einer Lichteintrittsfläche des optoelektronischen Bauelements angeordnet. Insbesondere können die erste und zweite Schnittfläche 30, 36 in Draufsicht unter der aktiven Schicht der optoelektronischen Bauelemente angeordnet sein.

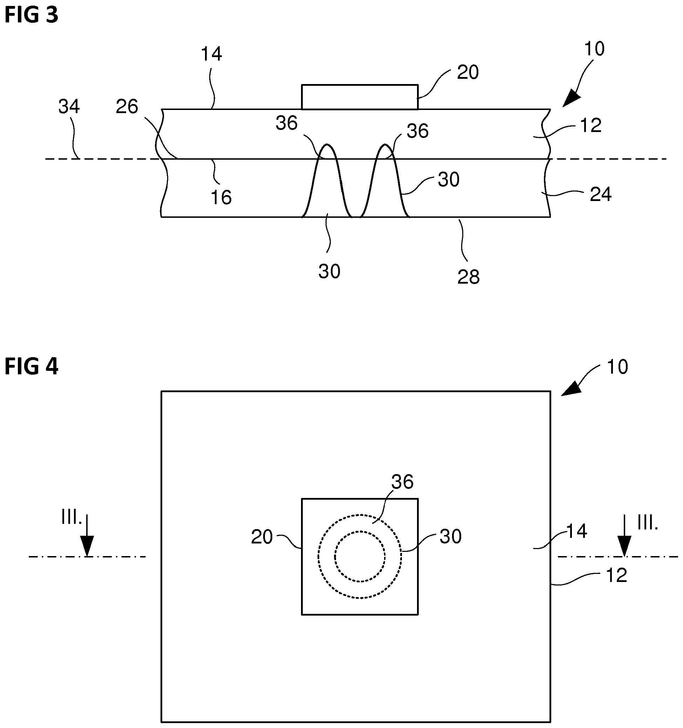

**Fig. 3** zeigt eine Schnittdarstellung eines Ausführungsbeispiels einer optoelektronischen Baugruppe 10 und **Fig. 4** zeigt eine Draufsicht auf die optoelektronische Baugruppe 10 gemäß Figur 3.

Die optoelektronische Baugruppe 10 kann beispielsweise weitgehend der im Vorhergehenden erläuterten optoelektronischen Baugruppe 10 entsprechen oder ein Teil dieser sein. Insbesondere kann das erste Bauelement 20 dem im Vorhergehenden erläuterten ersten Bauelement 20 entsprechen. Die erste Schweißverbindung 30 ist in Draufsicht kreisförmig ausgebildet. Dies bewirkt, dass die erste Schnittfläche 36 ringförmig ausgebildet ist. Das erste Bauelement 20 überlappt die erste Schnittfläche 36 zumindest teilweise, insbesondere vollständig. In Draufsicht umschließt die erste Schweißverbindung 30 eine kreisförmige Fläche vollständig. Ansonsten kann die erste Schweißverbindung 30 entsprechend der im Vorhergehenden erläuterten ersten Schweißverbindung 30 ausgebildet sein.

Die erste Schweißverbindung 30 kann beispielsweise von einer Schweißraupe gebildet sein. Beispielsweise kann ein Laserstrahl, der zum Ausbilden der ersten Schweißverbindung 30 verwendet wird, mäanderförmig entlang der in Figur 4 gezeigten Ringform der ersten Schnittfläche 36 geführt werden. Der innere und der äußere Durchmesser der ersten Schnittfläche 36 können beispielsweise von einer Größe des ersten Bauelements 20 abhängen. Beispielsweise kann der innere Durchmesser zwischen 1 mm und 10 mm, beispielsweise zwischen 2 mm und 8 mm, beispielsweise zwischen 3 mm und 6 mm groß sein.

Falls eine Beschichtung auf der zweiten Seite 16 oder der ersten Oberfläche 26 ausgebildet ist, so kann diese beispielsweise ausschließlich innerhalb der Ringform der ersten Schnittfläche 36 ausgebildet sein und von der ersten Schnittfläche 36 in radialer Richtung umschlossen sein. Die erste Schnittfläche 36 kann dann eine hermetische Abdichtung der Beschichtung bilden, was besonders vorteilhaft sein kann, falls die Beschichtung ein Material aufweist, das im Laufe der Zeit ausgast oder sich bei hohen Temperaturen löst, da die dabei entstehenden Gase bzw. gelösten Bestandteile dann zwischen der Leiterplatte 12, der Wärmesenke 24 und der ersten Schnittfläche 36 eingeschlossen sind. Die Haftung einer derartigen Beschichtung kann von geringer oder unwesentlicher Bedeutung sein, da die mechanische Verbindung im Wesentlichen oder ausschließlich von der ersten Schweißverbindung 30 gebildet sein kann. Die Beschichtung kann jedoch zur Verbesserung der Wärmeableitung beitragen.

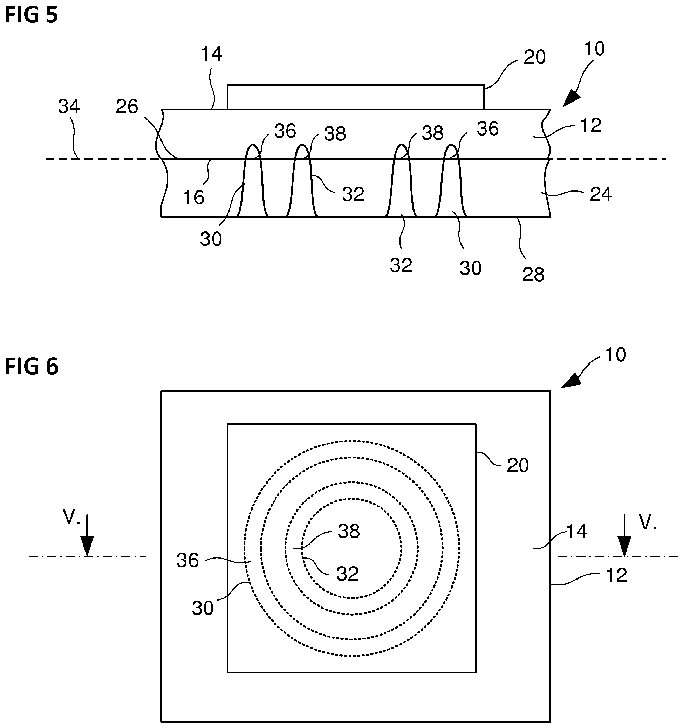

**Fig. 5** zeigt eine Schnittdarstellung eines Ausführungsbeispiels einer optoelektronischen Baugruppe 10 und **Fig. 6** zeigt eine Draufsicht auf die optoelektronische Baugruppe gemäß Figur 5.

Die optoelektronische Baugruppe 10 kann beispielsweise weitgehend einer der im Vorhergehenden erläuterten optoelektronischen Baugruppen 10 entsprechen oder ein Teil einer dieser sein. Insbesondere kann das erste Bauelement 20 dem im Vorhergehenden erläuterten ersten Bauelement 20 entsprechen. Die erste Schweißverbindung 30 ist in Draufsicht kreisförmig ausgebildet. Dies bewirkt, dass die erste Schnittfläche 36 ringförmig ausgebildet ist. Das erste Bauelement 20 überlappt die erste Schnittfläche 36 zumindest teilweise, insbesondere vollständig. In Draufsicht umschließt die erste Schweißverbindung 30 eine kreisförmige Fläche vollständig. Ansonsten kann die erste Schweißverbindung 30 entsprechend der im Vorhergehenden erläuterten ersten Schweißverbindung 30 ausgebildet sein. Die zweite Schweißverbindung 32 ist in Draufsicht kreisförmig ausgebildet und innerhalb und konzentrisch zu der ersten Schweißverbindung 30 angeordnet. Die zweite Schnittfläche 38 ist in Draufsicht ringförmig ausgebildet. Die zweite Schweißverbindung 32 umschließt eine kreisförmige Fläche vollständig. Ansonsten kann die zweite Schweißverbindung 30 entsprechend der im Vorhergehenden erläuterten zweiten Schweißverbindung 38 ausgebildet sein.

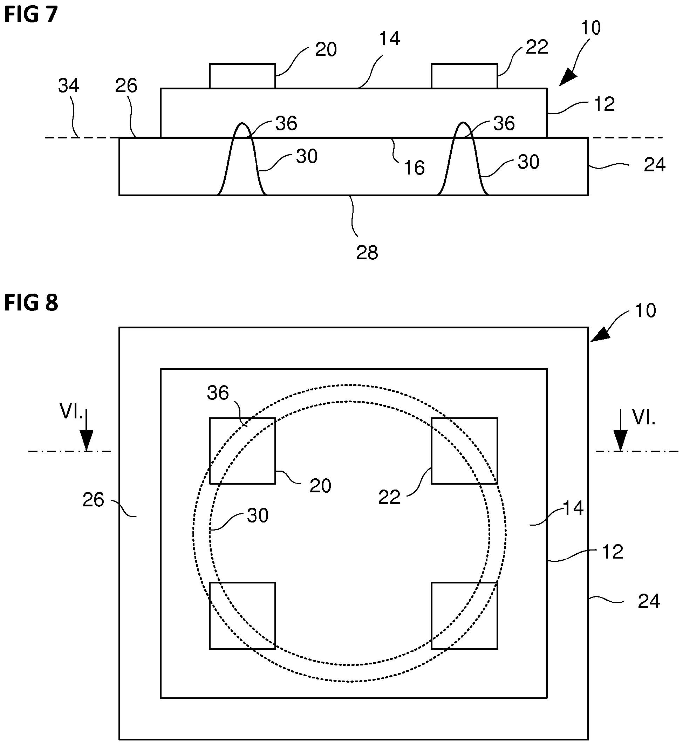

**Fig. 7** zeigt eine Schnittdarstellung eines Ausführungsbeispiels einer optoelektronischen Baugruppe 10 und **Fig. 8** zeigt eine Draufsicht auf die optoelektronische Baugruppe 10 gemäß Figur 7.

Die optoelektronische Baugruppe 10 kann beispielsweise weitgehend der im Vorhergehenden erläuterten optoelektronischen Baugruppe 10 entsprechen. Insbesondere können die Bauelemente 20, 22 den im Vorhergehenden erläuterten Bauelementen 20, 22 entsprechen. Die erste Schweißverbindung 30 ist in Draufsicht kreisförmig ausgebildet. Dies bewirkt, dass die erste Schnittfläche 36 ringförmig ausgebildet ist. Die Bauelemente 20, 22 überlappen die erste Schnittfläche 36 jeweils zumindest teilweise. Insbesondere überlappen die Bauelemente 20, 22 Segmente der ersten Schnittfläche 36. In Draufsicht umschließt die erste Schweißverbindung 30 eine kreisförmige Fläche vollständig. Ansonsten kann die erste Schweißverbindung 30 entsprechend der im Vorhergehenden erläuterten ersten Schweißverbindung 30 ausgebildet sein.

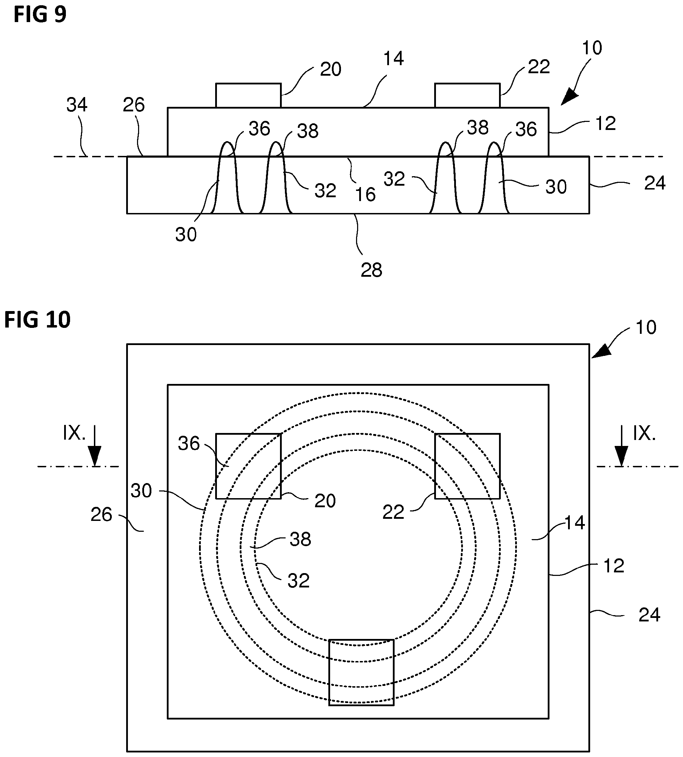

**Fig. 9** zeigt eine Schnittdarstellung eines Ausführungsbeispiels einer optoelektronischen Baugruppe 10 und **Fig. 10** zeigt eine Draufsicht auf die optoelektronische Baugruppe gemäß Figur 9.

Die optoelektronische Baugruppe 10 kann beispielsweise weitgehend einer der im Vorhergehenden erläuterten optoelektronischen Baugruppen 10 entsprechen. Insbesondere können die Bauelemente 20, 22 den im Vorhergehenden erläuterten Bauelementen 20, 22 entsprechen. Die erste Schweißverbindung 30 ist in Draufsicht kreisförmig ausgebildet. Dies bewirkt, dass die erste Schnittfläche 36 ringförmig ausgebildet ist. Die Bauelemente 20, 22 überlappen die erste Schnittfläche 36 jeweils zumindest teilweise. Insbesondere überlappen die Bauelemente 20, 22 Segmente der ersten Schnittfläche 36. In Draufsicht umschließt die erste Schweißverbindung 30 eine kreisförmige Fläche vollständig. Ansonsten kann die erste Schweißverbindung 30 entsprechend der im Vorhergehenden erläuterten ersten Schweißverbindung 30 ausgebildet sein. Die zweite Schweißverbindung 32 ist in Draufsicht kreisförmig ausgebildet und innerhalb und konzentrisch zu der ersten Schweißverbindung 30 angeordnet. Die Bauelemente 20, 22 überlappen die zweite Schnittfläche 38 jeweils zumindest teilweise. Insbesondere überlappen die Bauelemente 20, 22 Segmente der zweiten Schnittfläche 38. Die zweite Schnittfläche 38 ist in Draufsicht ringförmig ausgebildet. Die zweite Schweißverbindung 38 umschließt eine kreisförmige Fläche vollständig. Ansonsten kann die zweite Schweißverbindung 38 entsprechend der im Vorhergehenden erläuterten zweiten Schweißverbindung 38 ausgebildet sein.

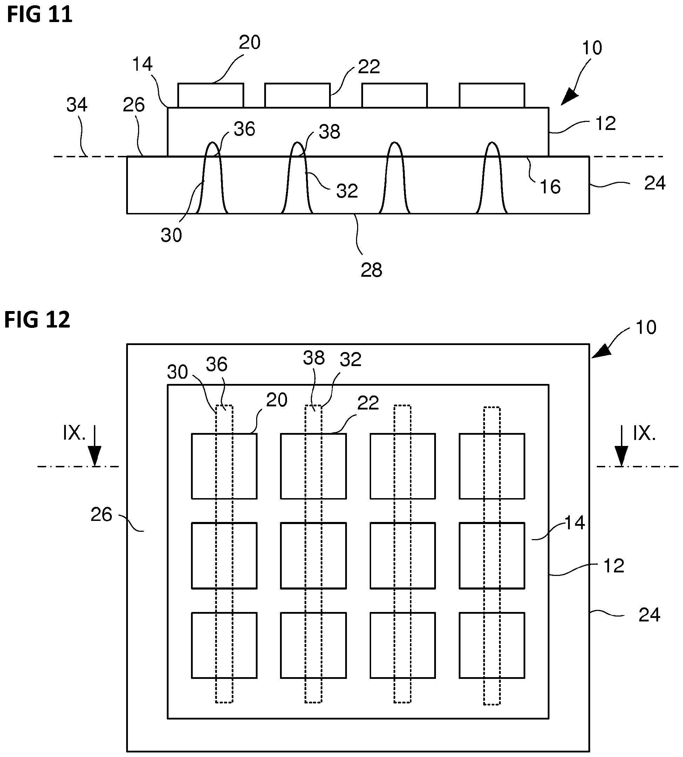

**Fig. 11** zeigt eine Schnittdarstellung eines Ausführungsbeispiels einer optoelektronischen Baugruppe 10 und **Fig. 12** zeigt eine Draufsicht auf die optoelektronische Baugruppe 10 gemäß Figur 11.

Die optoelektronische Baugruppe 10 kann beispielsweise weitgehend einer der im Vorhergehenden erläuterten optoelektronischen Baugruppen 10 entsprechen. Insbesondere können die Bauelemente 20, 22 den im Vorhergehenden erläuterten Bauelementen 20, 22 entsprechen. Die Bauelemente 20, 22 sind entlang von Zeilen und Spalten, insbesondere in Matrixform angeordnet. Die Schweißverbindungen 30, 32 sind in Draufsicht linienförmig und parallel zueinander ausgebildet. Die Schweißverbindungen 30, 32 sind entlang der Spalten angeordnet, die von den Bauelementen 20, 22 gebildet sind. Alternativ dazu können die Schweißverbindungen 30, 32 entlang der Zeilen angeordnet sein, die von den Bauelementen 20, 22 gebildet sind. Die Bauelemente 20, 22 überlappen die Schnittflächen 36, 38 jeweils zumindest teilweise. Ansonsten können die Schweißverbindungen 30, 32 entsprechend der im Vorhergehenden erläuterten Schweißverbindungen 30, 32 ausgebildet sein.

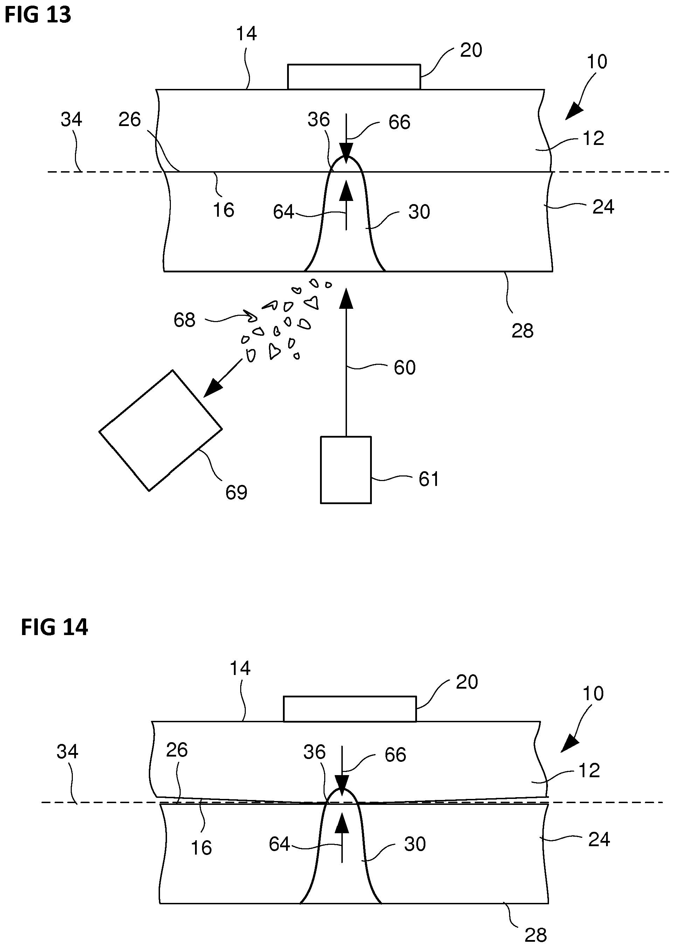

**Fig. 13** zeigt eine Schnittdarstellung eines Ausführungsbeispiels einer optoelektronischen Baugruppe 10 beim Herstellen einer Schweißverbindung. Die optoelektronische Baugruppe 10 kann beispielsweise weitgehend einer der im Vorhergehenden erläuterten optoelektronischen Baugruppen 10 entsprechen oder zumindest einen Teil dieser bilden. Die Schweißverbindung kann beispielsweise weitgehend einer der im Vorhergehenden erläuterten Schweißverbindungen 30, 32 entsprechen, beispielsweise der ersten Schweißverbindung 30.

Die erste Schweißverbindung 30 wird mittels eines Lasers 61 hergestellt, der einen Laserstrahls 60 erzeugt. Der Laserstrahl 60 wird von außen auf die zweite Oberfläche 28 der Wärmesenke 24 gestrahlt. In Figur 13 trifft der Laserstrahl 60 somit von unten auf die optoelektronische Baugruppe 10. Der Laserstrahl 60 wird derart auf die optoelektronische Baugruppe 10 gestrahlt, dass die erste Schweißverbindung 30 zumindest teilweise unter dem ersten Bauelement 20 ausgebildet wird, insbesondere so, dass das erste Bauelement 20 die erste Schnittfläche 36 zumindest teilweise überlappt.

Falls während des Ausbildens der ersten Schweißverbindung 30 Schmauch 68, also Partikel aufweisender Rauch, entsteht, so kann der Schmauch 68 mittels einer Absaugevorrichtung 69 abgesaugt werden.

Bei dem Ausbilden der ersten Schweißverbindung 30 werden das Material der Leiterplatte 12 und/oder der Wärmesenke 24 derart erhitzt, dass sie lokal aufschmelzen, wobei sich die Materialien der Wärmesenke 24 und der Leiterplatte 12 miteinander vermischen. Die Energie und die Wellenlänge des Laserstrahls 60 und die Dauer, während der der Laserstrahl 60 auf die optoelektronische Baugruppe 10 gestrahlt wird, müssen so gewählt werden, dass zwar einerseits die erste Schweißverbindung 30 entsteht, insbesondere die Materialien der Wärmesenke 24 und der Leiterplatte 12 aufschmelzen, jedoch die erzeugte Hitze nicht derart groß wird, dass das erste Bauelement 20 beschädigt wird. Nach dem Bestrahlen mittels des Laserstrahls 60 kühlt das aufgeschmolzene Material ab, erstarrt und bildet die stoffschlüssige und unmittelbare erste Schweißverbindung 30 zwischen der Wärmesenke 24 und der Leiterplatte 12.

Optional können die Wärmesenke 24 und/oder die Leiterplatte 12 während des Ausbildens der ersten Schweißverbindung 30 gekühlt werden. Dies kann dazu beitragen, zu verhindern, dass das erste Bauelement 20 zu stark erhitzt wird. Dies ermöglicht eine größere Freiheit bei der Wahl der geeigneten Energie bzw. der geeigneten Wellenlänge für den Laserstrahl 60. Die Kühlung kann beispielsweise mittels Luft- oder Gaskühlung, insbesondere mittels Anblasens der optoelektronischen Baugruppe 10 mittels Gas bzw. Luft, oder mittels direkten körperlichen Kontaktes der Wärmesenke 24 bzw. der Leiterplatte 12 zu einem nicht dargestellten Kühlkörper erfolgen.

Die Energie und/oder die Wellenlänge des Laserstrahls 60 und/oder eine Dauer der Bestrahlung ist so gewählt, dass sich die Leiterplatte 12 so stark erhitzt, dass dadurch auch eine stoffschlüssige Verbindung zwischen der Leiterplatte 12 und dem ersten Bauelement 20 erzeugt wird. Diese stoffschlüssige Verbindung kann beispielsweise eine Lötverbindung oder eine Schweißverbindung sein. Beispielsweise kann zwischen der Leiterplatte 12 und dem ersten Bauelement 20 Lot angeordnet sein, das beim Ausbilden der ersten Schweißverbindung 30 derart erhitzt wird, dass es schmilzt und nach dem Abkühlen das erste Bauelement 20 und die Leiterplatte 12 stoffschlüssig miteinander verbindet.

Der Laser 61 kann beispielsweise ein Nd:YAG-Laser sein. Die Schweißverbindungen 30, 32 können beispielsweise im Dauerstrichbetrieb hergestellt werden. Die Geometrien, insbesondere die Schweißraupengeometrie, kann mittels einer Scanneroptik erzeugt werden. Die Schweißverbindungen 30, 32 können mit einer Geschwindigkeit beispielsweise von ca. 100 mm/s hergestellt werden. Die Herstellungsdauer für die Schweißverbindungen 30, 32 kann insgesamt pro optoelektronischem Bauelement 10 ca. 1 s betragen, beispielsweise bei vier bis sechs in Draufsicht kreisförmigen Schweißverbindungen 30, 32. Ein Fokusdurchmesser des Laserstrahls 60 kann beispielsweise in einem Bereich von 10 µm bis 200 µm liegen, um bei schmalen Fokus eine geringe Gesamtwärmeenergie in die optoelektronische Baugruppe 10 einzubringen. Dies kann dazu beitragen, dass weder die Leiterplatte 12 noch das erste Bauelement 20 durch das direkt hinter dem ersten Bauelement 20 aufgeschmolzene Material beschädigt werden. Eine Energie des Lasers 61 kann beispielsweise ungefähr 950 W sein. Ferner kann der Laser 61 ein TruFiber 1000 Laser mit LLk 0,020 mm, PFO 20 fc=90 mm und f= 135 mm sein.

**Figur 14** zeigt eine Schnittdarstellung eines Ausführungsbeispiels einer optoelektronischen Baugruppe 10, die beispielsweise weitgehend einer der im Vorhergehenden erläuterten optoelektronischen Baugruppen 10 entsprechen kann oder einen Teil dieser bildet, nach dem Herstellen einer Schweißverbindung, die beispielsweise einer der im Vorhergehenden erläuterten Schweißverbindungen 30, 32 entsprechen kann. Bei diesem Ausführungsbeispiel liegen aufgrund von Bauteilungenauigkeiten und/oder Oberflächenrauigkeiten die zweite Seite 16 der Leiterplatte 12 und die erste Oberfläche 26 der Wärmesenke 24 nicht plan aneinander an, sondern haben in einigen Bereichen einen geringen Abstand zueinander, beispielsweise einen Abstand kleiner 2 mm. Wie im Vorhergehenden erläutert entstehen jedoch beim Abkühlen des mittels des Laserstrahls 60 aufgeschmolzenen Materials Schrumpfspannungen und die Leiterplatte 12 wird im Bereich der Schweißverbindungen 30, 32, insbesondere der ersten Schweißverbindung 30, zu der Wärmesenke 24 gezogen. Dadurch können lateral neben den Schweißverbindungen 30, 32 kleine Spalte entstehen, die jedoch aufgrund der besonders hohen thermischen Kopplung aufgrund der Schweißverbindungen 30, 32 vernachlässigt werden können.

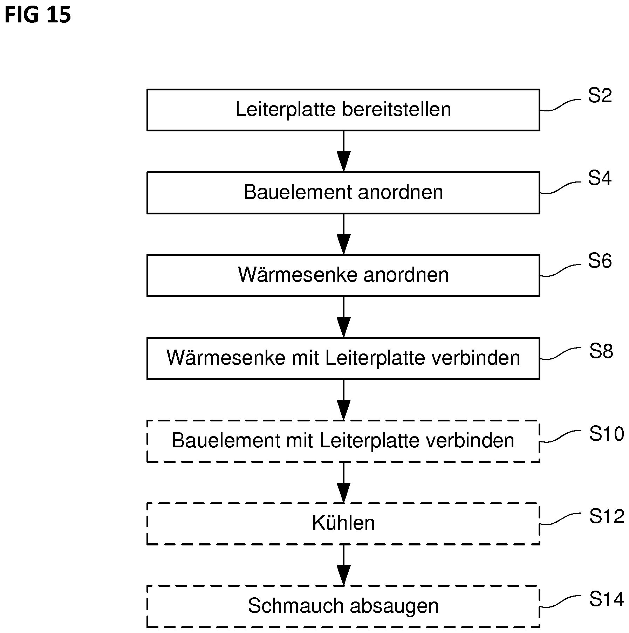

**Figur 15** zeigt ein Ablaufdiagramm eines Ausführungsbeispiels eines Verfahrens zum Herstellen einer optoelektronischen Baugruppe, beispielsweise einer der im Vorhergehenden erläuterten optoelektronischen Baugruppen 10.

In einem Schritt S2 wird eine Leiterplatte bereitgestellt, beispielsweise die im Vorhergehenden erläuterte Leiterplatte 12.

In einem Schritt S4 wird ein optoelektronisches Bauelement angeordnet. Beispielsweise wird eines der im Vorhergehenden erläuterten Bauelemente 20, 22 auf der Leiterplatte 12 angeordnet. Eine mechanische und/oder elektrische Verbindung der Bauelemente 20, 22 zu der Leiterplatte 12 wird (in Schritt S10) gleichzeitig mit dem Ausbilden der Schweißverbindungen 30, 32 hergestellt.

In einem Schritt S6 wird eine Wärmesenke angeordnet. Beispielsweise wird die Wärmesenke 24 an der Leiterplatte 12 angeordnet werden. Alternativ dazu kann die Leiterplatte 12 auf der Wärmesenke 24 angeordnet werden.

In einem Schritt S8 wird die Wärmesenke mit der Leiterplatte verbunden. Insbesondere wird die Wärmesenke 24 stoffschlüssig und unmittelbar mit der Leiterplatte 12 mittels eines Laserstrahls, beispielsweise des Laserstrahls 60, verbunden, insbesondere durch Ausbilden der ersten und/oder zweiten Schweißverbindung 30, 32. Insbesondere wird der Laserstrahl 60 von außen auf die zweite Oberfläche 26 der Wärmesenke 24 derart gestrahlt, dass zumindest innerhalb des Focus des Laserstrahls 60 das Material der Wärmesenke 24 über die gesamte Dicke der Wärmesenke 24 und das Material der Leiterplatte 12 mit einer Tiefe, die beispielsweise 5% bis 50%, beispielsweise ungefähr 20% der Dicke der Leiterplatte 12 entspricht, geschmolzen werden. Der Laserstrahl 60 kann beispielsweise mittels des im Vorhergehenden erläuterten Lasers 61 erzeugt werden. Anschließend kühlen die Schweißverbindungen 30, 32 ab und das vermischte Material erstarrt wodurch die stoffschlüssige und unmittelbare Verbindung der Leiterplatte 12 mit der Wärmesenke 24 gegeben ist.

In dem Schritt S10 wird gleichzeitig zu dem Schritt S8 ein Bauelement mit der Leiterplatte verbunden. Genauer wird das erste Bauelement 20 mit der Leiterplatte 12 verbunden, während die erste Schweißverbindung 30 ausgebildet wird. Insbesondere wird das erste Bauelement 20 mit der Leiterplatte 12 verbunden aufgrund der Hitze, die während des Ausbildens der ersten Schweißverbindung 30 entsteht.

In einem optionalen Schritt S12 wird gleichzeitig zu dem Schritt S8 die optoelektronische Baugruppe 10 gekühlt, beispielsweise wie bereits im Vorhergehenden erläutert.

In einem optionalen Schritt S14 wird gleichzeitig zu dem Schritt S8 Schmauch 68 abgesaugt, der beim Ausbilden der ersten Schweißverbindung 30 entsteht, beispielsweise wie bereits im Vorhergehenden erläutert.

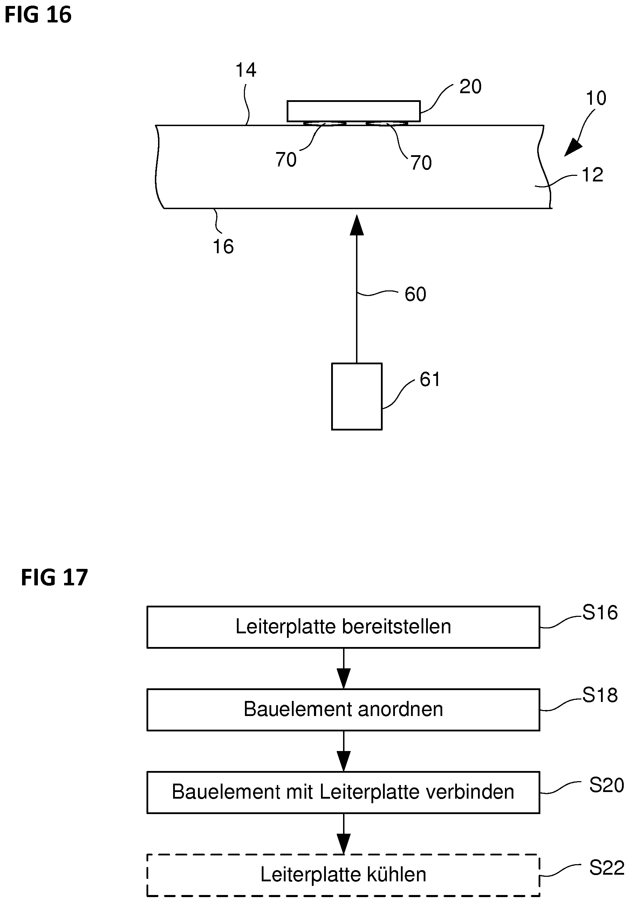

**Figur 16** zeigt eine Schnittdarstellung eines Ausführungsbeispiels einer optoelektronischen Baugruppe 10 beim Herstellen einer stoffschlüssigen Verbindung. Die optoelektronische Baugruppe 10 weist die Leiterplatte 12 und das erste Bauelement 20 auf. Optional kann die optoelektronische Baugruppe 10 noch weitere Bauelemente 20, 22 aufweisen. Zwischen dem ersten Bauelement 20 und der Leiterplatte 12 ist Lot 70 angeordnet. Mittels eines Laserstrahls 60, der mithilfe eines Lasers 61 erzeugt wird, wird die Leiterplatte 12 derart erhitzt, dass das Lot 70 schmilzt. Der Laserstrahl 60 wird von außen auf die zweite Seite 16 der Leiterplatte 12 gestrahlt. Nach dem Bestrahlen der Leiterplatte 12 mittels des Laserstrahls 60 kühlen die Leiterplatte 12 und das aufgeschmolzenen Lot 70 ab und das Lot 70 verbindet die Leiterplatte 12 mittelbar mit dem ersten Bauelement 20. Das gehärtete Lot bildet eine stoffschlüssige und mittelbare Verbindung, insbesondere eine mechanische und/oder elektrische Verbindung, zwischen der Leiterplatte 12 und dem ersten Bauelement 20.

**Figur 17** zeigt ein Ablaufdiagramm eines Ausführungsbeispiels eines Verfahrens zum Herstellen einer optoelektronischen Baugruppe 10, die beispielsweise der mit Bezug zu Figur 16 erläuterten optoelektronischen Baugruppe 10 entsprechen kann.

In einem Schritt S16 wird eine Leiterplatte bereitgestellt, beispielsweise die im Vorhergehenden erläuterte Leiterplatte 12.

In einem Schritt S18 wird ein optoelektronisches Bauelement angeordnet. Beispielsweise wird das im Vorhergehenden erläuterte erste Bauelement 20 auf der Leiterplatte 12 angeordnet.

In einem Schritt S20 wird die Leiterplatte 12 mit dem ersten Bauelement 20 verbunden. Insbesondere wird die Leiterplatte 12 stoffschlüssig und mittelbar mit dem ersten Bauelement 20 mittels eines Laserstrahls, beispielsweise des Laserstrahls 60, verbunden. Insbesondere wird der Laserstrahl 60 von außen auf die zweite Oberfläche 26 der Wärmesenke 24 derart gestrahlt, dass das Lot 70 schmilzt.

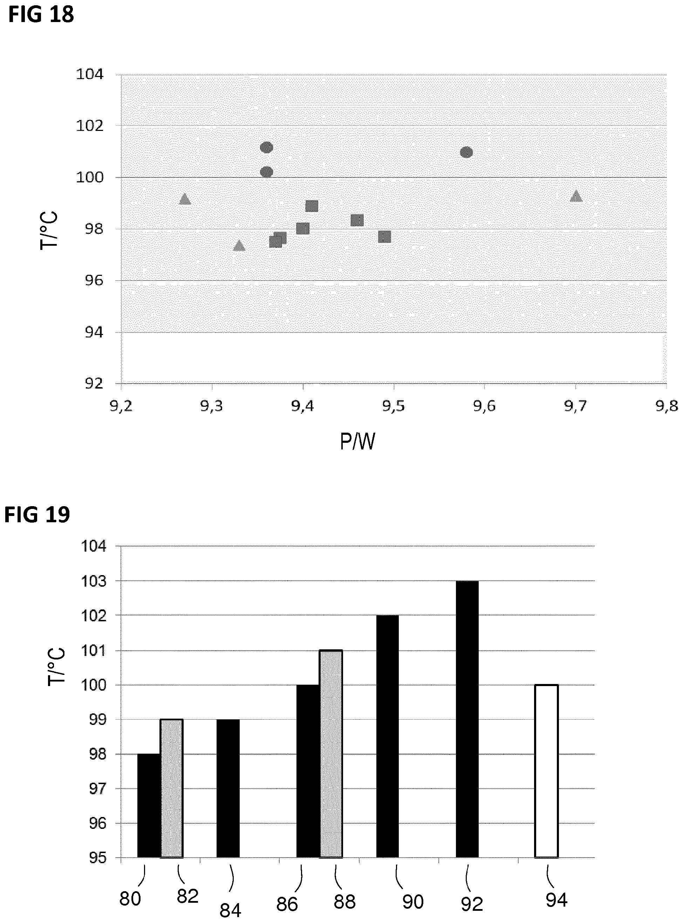

**Fig. 18** zeigt ein erstes Diagramm mit ersten Messergebnissen. Bei dem ersten Diagramm ist entlang der X-Achse die Leistung des Lasers 61 aufgetragen und entlang der Y-Achse die Temperatur einer Lötstelle, an der eines der Bauelemente 20, 22 mit der Leiterplatte 12 verbunden ist, während des Betriebs der optoelektronischen Baugruppe 10. Die Temperatur der Lötstelle ist repräsentativ für eine Güte der Wärmeableitung von dem entsprechenden Bauelement 20, 22 über die Leiterplatte 12 zu der Wärmesenke 24. Insbesondere ist die die Wärmeableitung von dem entsprechenden Bauelement 20, 22 über die Leiterplatte 12 zu der Wärmesenke 24 umso besser, je geringer die Temperatur der Lötstelle während des Betriebs der optoelektronischen Baugruppe 10 ist.

Die kreisförmigen Messpunkte entsprechen Messungen, bei denen die Leiterplatte 12 mit der Wärmesenke 24 ausschließlich mittels eines herkömmlichen preisgünstigen Wärmeleitklebers verbunden ist. Die kreisförmigen Messpunkte liegen alle über 100°C.

Die dreieckförmigen Messpunkte entsprechen Messungen, bei denen die Leiterplatte 12 mit der Wärmesenke 24 ausschließlich mittels eines herkömmlichen hochwertigen Wärmeleitklebers verbunden ist. Die dreieckförmigen Messpunkte liegen alle zwischen 97°C und 100°C. Somit liegen die dreieckförmigen Messpunkte unter den kreisförmigen Messpunkten. Dies bedeutet, dass mittels des hochwertigen Wärmeleitklebers eine bessere Wärmeableitung gegeben ist als mittels des preisgünstigen Wärmeleitklebers.

Die quadratischen Messpunkte entsprechen Messungen, bei denen die Leiterplatte 12 mit der Wärmesenke 24 ausschließlich mittels Schweißverbindungen 30, 32, die direkt hinter bzw. unter den Bauelementen 20, 22 ausgebildet sind, verbunden ist. Die quadratischen Messpunkte liegen alle zwischen 97°C und 100°C. Somit liegen die quadratischen Messpunkte im Bereich der dreieckförmigen Messpunkte. Dies bedeutet, dass mittels der Schweißverbindungen 30, 32 direkt hinter bzw. unter den Bauelementen 20, 22 eine Wärmeableitung gegeben ist, die mit der bei Verwendung eines hochwertigen Wärmeleitklebers vergleichbar ist.

Beim Erfassen der ersten Messergebnisse ist die verwendete optoelektronische Baugruppe 10 immer die gleiche, lediglich die erfasste Leistung variiert von Messung zu Messung

**Figur 19** zeigt ein zweites Diagramm mit zweiten Messergebnissen. Entlang der X-Achse sind vertikale Balken angetragen, die für verschiedene Geometrien der Schweißverbindungen 30, 32 repräsentativ sind. Entlang der Y-Achse sind die Temperaturen einer Lötstelle zwischen einem der Bauelemente 20, 22 und der Leiterplatte 12 während des Betriebs der optoelektronischen Baugruppe 10 angetragen.

Ein erster Balken 80 zeigt, dass die Temperatur der Lötstelle während des Betriebs der optoelektronischen Baugruppe 10 bei 98°C liegt. Der erste Balken 80 und die entsprechende Temperatur wurden aufgezeichnet mithilfe einer optoelektronischen Baugruppe 10, die vier Bauelemente 20, 22 aufweist, die in Draufsicht in den Ecken eines Quadrat angeordnet sind, wie beispielsweise in Figur 8 gezeigt, und bei der die Leiterplatte 12 mit der Wärmesenke 24 mittels 18 in Draufsicht kreisförmigen Schweißverbindungen 30, 32 verbunden ist. Dabei sind die Schweißverbindungen 30, 32 paarweise konzentrisch ausgebildet, wie beispielsweise in Figur 6 gezeigt, wobei hinter jedem der vier Bauelemente 20, 22 je ein Paar dieser konzentrischen Schweißverbindungen 30, 32 ausgebildet ist und wobei die übrigen Schweißverbindungen 30, 32 auch paarweise konzentrisch ausgebildet sind und in Draufsicht zwischen den Bauelementen 20, 22 angeordnet sind. Anschaulich gesprochen sind die Paare der konzentrisch ausgebildeten Schweißverbindungen 30, 32 in Draufsicht an den einzelnen Zellen einer Matrixform mit drei Zeilen und drei Spalten ausgebildet, wobei die Bauelemente 20, 22 an den äußeren Ecken der Matrixform angeordnet sind.

Ein zweiter Balken 82 zeigt, dass die Temperatur der Lötstelle während des Betriebs der optoelektronischen Baugruppe 10 bei 99°C liegt. Der zweite Balken 32 und die entsprechende Temperatur wurden mit der gleichen optoelektronischen Baugruppe 10 erfasst wie der erste Balken 80.

Ein dritter Balken 84 zeigt, dass die Temperatur der Lötstelle während des Betriebs der optoelektronischen Baugruppe 10 bei 99°C liegt. Der dritte Balken 84 und die entsprechende Temperatur wurden aufgezeichnet mithilfe einer optoelektronischen Baugruppe 10, die vier Bauelemente 20, 22 aufweist, die in Draufsicht in den Ecken eines Quadrat angeordnet sind, wie beispielsweise in Figur 8 gezeigt, und bei der die Leiterplatte 12 mit der Wärmesenke 24 mittels vier in Draufsicht kreisförmigen Schweißverbindungen 30, 32 verbunden ist. Dabei ist hinter jedem der vier Bauelemente 20, 22 eine der Schweißverbindungen 30, 32 ausgebildet.

Ein vierter Balken 86 zeigt, dass die Temperatur der Lötstelle während des Betriebs der optoelektronischen Baugruppe 10 bei 100°C liegt. Der vierte Balken 86 und die entsprechende Temperatur wurden mit der gleichen optoelektronischen Baugruppe 10 erfasst wie der dritte Balken 84, jedoch wurde vor dem Ausbilden der Schweißverbindungen 30, 32 künstlich ein Spalt von 0,22 mm Größe zwischen der Leiterplatte 12 und der Wärmesenke 24 erzeugt. Dieser Spalt wurde beim Herstellen der Schweißverbindungen 32, 32 wie in Figur 14 gezeigt überbrückt.

Ein fünfter Balken 88 zeigt, dass die Temperatur der Lötstelle während des Betriebs der optoelektronischen Baugruppe 10 bei 101°C liegt. Der fünfte Balken 88 und die entsprechende Temperatur wurden mit der gleichen optoelektronischen Baugruppe 10 erfasst wie der vierte Balken 86.

Ein sechster Balken 90 zeigt, dass die Temperatur der Lötstelle während des Betriebs der optoelektronischen Baugruppe 10 bei 102°C liegt. Der sechste Balken 90 und die entsprechende Temperatur wurden aufgezeichnet mithilfe einer optoelektronischen Baugruppe 10, die vier Bauelemente 20, 22 aufweist, die in Draufsicht in den Ecken eines Quadrat angeordnet sind, wie beispielsweise in Figur 8 gezeigt, und bei der die Leiterplatte 12 mit der Wärmesenke 24 mittels zwei in Draufsicht kreisförmigen Schweißverbindungen 30, 32 verbunden ist. Dabei sind die Schweißverbindungen 30, 32 konzentrisch ausgebildet, wie beispielsweise in Figur 10 gezeigt, wobei hinter jedem der vier Bauelemente 20, 22 je zumindest ein Segment dieser konzentrischen Schweißverbindungen 30, 32 ausgebildet ist.

Ein siebter Balken 92 zeigt, dass die Temperatur der Lötstelle während des Betriebs der optoelektronischen Baugruppe 10 bei 103°C liegt. Der siebte Balken 92 und die entsprechende Temperatur wurden aufgezeichnet mithilfe einer optoelektronischen Baugruppe 10, die vier Bauelemente 20, 22 aufweist, die in Draufsicht in den Ecken eines Quadrat angeordnet sind, wie beispielsweise in Figur 8 gezeigt, und bei der die Leiterplatte 12 mit der Wärmesenke 24 mittels einer in Draufsicht kreisförmigen Schweißverbindung 30 verbunden ist, wie beispielsweise in Figur 8 gezeigt.

Ein achter Balken 94 zeigt, dass die Temperatur der Lötstelle während des Betriebs der optoelektronischen Baugruppe 10 bei 100°C liegt. Der achte Balken 94 und die entsprechende Temperatur wurden aufgezeichnet mithilfe einer optoelektronischen Baugruppe 10, die vier Bauelemente 20, 22 aufweist, die in Draufsicht in den Ecken eines Quadrat angeordnet sind, wie beispielsweise in Figur 8 gezeigt, und bei der die Leiterplatte 12 mit der Wärmesenke 24 mittels eines hochwertigen Wärmeleitklebers verbunden ist.

Das zweite Diagramm und die zweiten Messergebnisse zeigen, dass die Wärmeableitung bei den optoelektronischen Baugruppen 10, bei denen die Leiterplatte 12 mit der Wärmesenke 24 ausschließlich mittels der Schweißverbindungen 30, 32, die zumindest teilweise hinter den Bauelementen 20, 22 ausgebildet sind, grundsätzlich im Bereich der Wärmeableitung der optoelektronischen Baugruppen 10 liegt, bei denen die Leiterplatte 12 mit der Wärmesenke 24 ausschließlich mittels des hochwertigen Wärmeleitklebers verbunden ist. Dabei nimmt die Güte der Wärmeableitung mit der Anzahl der Schweißverbindungen 30, 32 zu. Außerdem wirkt es sich positiv auf die Wärmeableitung aus, wenn zu jedem Bauelement 20, 22 eine oder zwei eigene Schweißverbindungen 30, 32 ausgebildet sind, deren Schnittflächen 36, 38 ausschließlich von den entsprechenden Bauelementen 20, 22 überlappt werden. Des Weiteren zeigen insbesondere der vierte und der fünfte Balken 86, 88, dass selbst bei einem Spalt zwischen der Leiterplatte 12 und der Wärmesenke 24 die Wärmeableitung aufgrund der Schweißverbindungen 30, 32 ausreichend hoch ist.

Die optoelektronische Baugruppe 10 kann beispielsweise eine OSRAM Classic Superstar A60 Lampe sein.

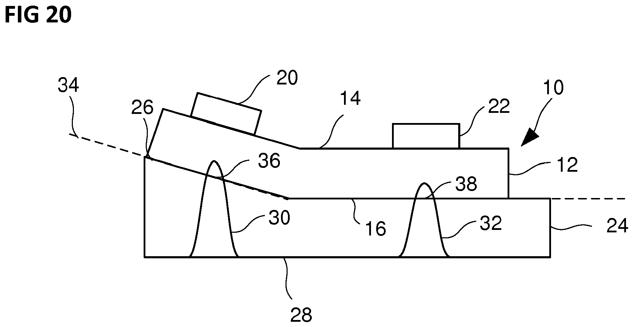

**Fig. 20** zeigt ein Ausführungsbeispiel einer optoelektronischen Baugruppe 10, die beispielsweise weitgehend einer der im vorher stehenden erläuterten optoelektronischen Baugruppen 10 entsprechen kann. Bei der optoelektronischen Baugruppe 10 weisen die zweite Seite 16 der Leiterplatte 12 und die erste Oberfläche 26 der Wärmesenke 24 einen Knick auf. Die Grenzfläche 34 weist einen dazu korrespondierenden Knick auf. In anderen Worten weist die Wärmesenke 24 eine Schräge auf und die Leiterplatte 12 und die Grenzfläche 34 sind an die Schräge angepasst.

Die Erfindung ist nicht auf die angegebenen Ausführungsbeispiele beschränkt. Beispielsweise können die gezeigten Ausführungsbeispiele miteinander kombiniert werden. Beispielsweise können die gezeigten optoelektronischen Baugruppen 10 mehr oder weniger der gezeigten Bauelemente 20, 22 aufweisen. Ferner können die gezeigten optoelektronischen Baugruppen 10 mehr oder weniger der gezeigten Schweißverbindungen 30, 32 aufweisen. Beispielsweise können zusätzlich zu den direkt hinter bzw. unter den Bauelementen 20, 22 ausgebildeten Schweißverbindungen 30, 32 weitere Schweißverbindungen vorgesehen sein, die nicht direkt hinter bzw. unter den Bauelementen 20, 22 ausgebildet sind. Ferner können die Schweißverbindungen 30, 32 in Draufsicht andere Formen aufweisen, beispielsweise polygonalen Formen, insbesondere dreieckige, viereckige, insbesondere quadratische, oder kreisförmige oder rundliche Formen, insbesondere elliptische Formen. Des Weiteren können alle der gezeigten Schweißverbindungen 30, 32 in den grob dargestellten Draufsichten die gezeigten Formen aufweisen im Detail jedoch von mäanderförmig Linien, den Schweißraupen, gebildet sein, die in den groben Draufsichten dann die gezeigten Formen bilden.

## Patentansprüche

1. Optoelektronische Baugruppe (10), mit
einer Leiterplatte (12),
mindestens einem optoelektronischen ersten Bauelement (20), das auf einer ersten Seite (14) der Leiterplatte (12) angeordnet ist,
einer Wärmesenke (24), die eine erste Oberfläche (26) aufweist und die mit ihrer ersten Oberfläche (26) an einer von dem ersten Bauelement (20) abgewandten zweiten Seite (16) der Leiterplatte (12) angeordnet ist, wobei sich zwischen der zweiten Seite (16) und der ersten Oberfläche (26) eine Grenzfläche (34) erstreckt, und
mindestens einer ersten Schweißverbindung (30), mittels der die Wärmesenke (24) unmittelbar und stoffschlüssig mit der Leiterplatte (12) verbunden ist und die eine erste Schnittfläche (36) mit der Grenzfläche (34) bildet, wobei das erste Bauelement (20) die erste Schnittfläche (36) zumindest teilweise überlappt, wobei das erste Bauelement (20) mittels einer Lötverbindung oder einer zweiten Schweißverbindung an der Leiterplatte (12) befestigt ist, **dadurch gekennzeichnet, dass** die Lötverbindung oder die zweite Schweißverbindung beim Ausbilden der ersten Schweißverbindung mittels eines Laserstrahls aufgeschmolzen worden ist, um das erste Bauelement (20) stoffschlüssig mit der Leiterplatte zu verbinden.

2. Optoelektronische Baugruppe (10) nach Anspruch 1, bei der das erste Bauelement (20) die erste Schnittfläche (36) vollständig überlappt.

3. Optoelektronische Baugruppe (10) nach einem der Ansprüche 1 oder 2, bei der sich die erste Schweißverbindung (30) durch die gesamte Dicke der Wärmesenke (24) hindurch erstreckt.

4. Optoelektronische Baugruppe (10) nach einem der vorstehenden Ansprüche, bei der die erste Schweißverbindung (30) in Richtung parallel zu der Grenzfläche (34) linienförmig, insbesondere geradlinig, polygonal, kreisförmig und/oder mäanderförmig ausgebildet ist.

5. Optoelektronische Baugruppe (10) nach Anspruch 4, bei der die erste Schweißverbindung (30) kreisförmig ausgebildet ist und bei der mindestens eine zweite Schweißverbindung (32) ausgebildet ist, mittels der die Wärmesenke (24) unmittelbar und stoffschlüssig mit der Leiterplatte (12) verbunden ist, die eine zweite Schnittfläche (38) mit der Grenzfläche (34) bildet und die konzentrisch zu der ersten Schweißverbindung (30) ausgebildet ist.

6. Optoelektronische Baugruppe (10) nach Anspruch 4, bei der die erste Schweißverbindung (30) geradlinig ausgebildet ist und bei der mindestens eine zweite Schweißverbindung (32) ausgebildet ist, mittels der die Wärmesenke (24) unmittelbar und stoffschlüssig mit der Leiterplatte (12) verbunden ist, die eine zweite Schnittfläche (38) mit der Grenzfläche (34) bildet und die parallel zu der ersten Schweißverbindung (30) ausgebildet ist.

7. Optoelektronische Baugruppe (10) nach einem der Ansprüche 5 oder 6, die mindestens ein optoelektronisches zweites Bauelement (22) aufweist, das auf der ersten Seite (14) der Leiterplatte (12) angeordnet ist und das die erste Schnittfläche (36) und/oder die zweite Schnittfläche (38) zumindest teilweise überlappt.

8. Optoelektronische Baugruppe (10) nach einem der vorstehenden Ansprüche, bei der die erste Schweißverbindung (30) und/oder die zweite Schweißverbindung (32) mit einer Tiefe in die Leiterplatte (12) hineinragen, die 5% bis 50% der Dicke der Leiterplatte (12) entspricht.

9. Optoelektronisches Baugruppe (10) nach einem der vorhergehenden Ansprüche, wobei eine aktive Schicht des ersten Bauelements (20) und die erste Schnittfläche (36) zumindest teilweise überlappen.

10. Verfahren zum Herstellen einer optoelektronischen Baugruppe (10), bei dem
eine Leiterplatte (12) bereitgestellt wird, mindestens ein optoelektronisches erstes Bauelement (20) auf einer ersten Seite (14) der Leiterplatte (12) angeordnet wird,
an einer von der ersten Seite (14) abgewandten zweiten Seite (16) der Leiterplatte (12) eine erste Oberfläche (26) einer Wärmesenke (24) angeordnet wird, wobei sich zwischen der zweiten Seite (16) und der ersten Oberfläche (26) eine Grenzfläche (34) erstreckt, und
die Leiterplatte (12) mittels mindestens einer ersten Schweißverbindung (30) unmittelbar und stoffschlüssig mit der Wärmesenke (24) verbunden wird, wobei die erste Schweißverbindung (30) mittels eines Laserstrahls (60), der von außen auf eine von der Leiterplatte (12) abgewandte zweite Oberfläche der Wärmesenke (24) gestrahlt wird, so ausgebildet wird, dass die erste Schweißverbindung (30) eine erste Schnittfläche (36) mit der Grenzfläche (34) bildet und dass das erste Bauelement (20) die erste Schnittfläche (36) zumindest teilweise überlappt, **dadurch gekennzeichnet, dass** gleichzeitig zu dem Ausbilden der ersten Schweißverbindung (30) mittels desselben Laserstrahls (60), mit dem die erste Schweißverbindung (30) ausgebildet wird, das erste Bauelement (20) stoffschlüssig mit der Leiterplatte (12) verbunden wird.

11. Verfahren nach Anspruch 10, bei dem die Wärmesenke (24) und/oder die Leiterplatte (12) während des Ausbildens der ersten Schweißverbindung (30) gekühlt werden.

12. Verfahren nach einem der Ansprüche 10 oder 11, bei dem Schmauch (68), der bei dem Ausbilden der ersten Schweißverbindung (30) entsteht, während des Ausbildens der ersten Schweißverbindung (30) abgesaugt wird.

13. Verfahren nach einem der Ansprüche 10 bis 12, bei dem mindestens eine zweite Schweißverbindung (32) ausgebildet wird, mittels der die Leiterplatte (12) an deren zweiten Seite (16) mit der ersten Oberfläche (26) der Wärmesenke (24) unmittelbar und stoffschlüssig verbunden wird, wobei die zweite Schweißverbindung (32) mittels eines Laserstrahls (60), der von außen auf die zweite Oberfläche der Wärmesenke (24) gestrahlt wird, ausgebildet wird.

## Claims

1. Optoelectronic assembly (10), with
a printed circuit board (12),
at least one optoelectronic first component (20) arranged on a first side (14) of the printed circuit board (12),
a heat sink (24) which has a first surface (26) and which is arranged with its first surface (26) on a second side (16) of the printed circuit board (12) facing away from the first component (20), wherein an boundary surface (34) extends between the second side (16) and the first surface (26), and
at least one first welded joint (30), by means of which the heat sink (24) is connected directly and in a materially-bonded manner to the printed circuit board (12) and which forms a first intersection (36) with the boundary surface (34), wherein the first component (20) overlaps at least partially the first intersection (36), wherein the first component (20) is fixed to the printed circuit board (12) by means of a soldered joint or a second welded joint, **characterized in that** the soldered joint or the second welded joint has been melted by means of a laser beam during the formation of the first welded joint in order to connect the first component (20) to the printed circuit board in a material-bonded manner.

2. Optoelectronic assembly (10) according to claim 1, in which the first component (20) completely overlaps the first intersection (36).

3. Optoelectronic assembly (10) according to one of claims 1 or 2, in which the first welded joint (30) extends through the entire thickness of the heat sink (24).

4. Optoelectronic assembly (10) according to one of the above claims, in which the first welded joint (30) is linear, in particular rectilinear, polygonal, circular and/or meandering in the direction parallel to the boundary surface (34).

5. Optoelectronic assembly (10) according to claim 4, in which the first welded joint (30) is of circular design and in which at least one second welded joint (32) is formed, by means of which the heat sink (24) is connected directly and in a material-bonded manner to the printed circuit board (12), which forms a second intersection (38) with the boundary surface (34) and which is formed concentrically to the first welded joint (30).

6. Optoelectronic assembly (10) according to claim 4, in which the first welded joint (30) is formed in a straight line and in which at least one second welded joint (32) is formed, by means of which the heat sink (24) is connected directly and in materially-bonded manner to the printed circuit board (12), which forms a second intersection (38) with the boundary surface (34) and which is formed parallel to the first welded joint (30).

7. Optoelectronic assembly (10) according to one of claims 5 or 6, which has at least one optoelectronic second component (22) which is arranged on the first side (14) of the printed circuit board (12) and which at least partially overlaps the first intersection (36) and/or the second intersection (38).

8. Optoelectronic assembly (10) according to one of the above claims, in which the first welded joint (30) and/or the second welded joint (32) protrude into the printed circuit board (12) to a depth corresponding to 5% to 50% of the thickness of the printed circuit board (12).

9. Optoelectronic assembly (10) according to one of the preceding claims, wherein an active layer of the first component (20) and the first intersection (36) at least partially overlap.

10. Method of manufacturing an optoelectronic assembly (10), in which
a printed circuit board (12) is provided,
at least one optoelectronic first component (20) is arranged on a first side (14) of the printed circuit board (12),
a first surface (26) of a heat sink (24) is arranged on a second side (16) of the circuit board (12) facing away from the first side (14), wherein an boundary surface (34) extends between the second side (16) and the first surface (26), and
the printed circuit board (12) is connected directly and in a materially-bonded manner to the heat sink (24) by means of at least one first welded joint (30), the first welded joint (30) being formed by means of a laser beam (60) which is radiated from outside onto a second surface of the heat sink (24) facing away from the printed circuit board (12), in that the first welded joint (30) forms a first intersection (36) with the boundary surface (34), and in that the first component (20) at least partially overlaps the first intersection (36), **characterized in that**, simultaneously with the formation of the first welded joint (30) by means of the same laser beam (60) with which the first welded joint (30) is formed, the first component (20) is connected to the printed circuit board (12) in a materially-bonded manner.

11. Method according to claim 10, in which the heat sink (24) and/or the printed circuit board (12) are cooled during the formation of the first welded joint (30).

12. Method according to one of claims 10 or 11, in which smoke (68) which is produced during the formation of the first welded joint (30) is extracted during the formation of the first welded joint (30).

13. Method according to one of claims 10 to 12, in which at least one second welded joint (32) is formed, by means of which the printed circuit board (12) is connected directly and in a materially-bonded manner on its second side (16) to the first surface (26) of the heat sink (24), wherein the second welded joint (32) is formed by means of a laser beam (60) which is radiated from outside onto the second surface of the heat sink (24).

## Revendications

1. Assemblage optoélectronique (10), avec
une carte de circuit imprimé (12),
au moins un premier composant optoélectronique (20) disposé sur une première face (14) de la carte de circuit imprimé (12),
un dissipateur de chaleur (24) qui comprend une première surface (26) et qui est disposé avec sa première surface (26) sur une deuxième face (16) de la carte de circuit imprimé (12) opposée au premier composant (20), une surface de délimitation (34) s'étendant entre la deuxième face (16) et la première surface (26), et
au moins un premier joint soudé (30), au moyen duquel le dissipateur de chaleur (24) est relié directement et par liaison de matière à la carte de circuit imprimé (12) et qui forme une première surface d'intersection(36) avec la surface de délimitation (34), le premier composant (20) recouvrant au moins partiellement la première surface d'intersection (36), dans lequel le premier composant (20) est fixé à la carte de circuit imprimé (12) au moyen d'une jonction par brasage ou d'un second joint soudé, **caractérisé en ce que** la jonction par brasage ou le second joint soudé a été fondu au moyen d'un faisceau laser pendant la formation du premier joint soudé afin de relier le premier composant (20) à la carte de circuit imprimé de manière matériellement liée.

2. Assemblage optoélectronique (10) selon la revendication 1, dans lequel le premier composant (20) chevauche complètement la première surface d'intersection (36).

3. Assemblage optoélectronique (10) selon l'une des revendications 1 ou 2, dans lequel le premier joint soudé (30) s'étend sur toute l'épaisseur du dissipateur de chaleur (24).

4. Assemblage optoélectronique (10) selon l'une des revendications ci-dessus, dans lequel le premier joint soudé (30) est linéaire, notamment rectiligne, polygonal, circulaire et/ou en méandres dans la direction parallèle à la surface de délimitation (34).

5. Assemblage optoélectronique (10) selon la revendication 4, dans lequel le premier joint soudé (30) est de forme circulaire et dans lequel est formé au moins un deuxième joint soudé (32), au moyen duquel le dissipateur de chaleur (24) est relié directement et par liaison de matière à la carte de circuit imprimé (12), qui forme une deuxième surface d'intersection (38) avec la surface de délimitation (34) et qui est formée concentriquement au premier joint soudé (30).

6. Assemblage optoélectronique (10) selon la revendication 4, dans lequel le premier joint soudé (30) est formé en ligne droite et dans lequel est formé au moins un deuxième joint soudé (32), au moyen duquel le dissipateur de chaleur (24) est relié directement et par liaison de matière à la carte de circuit imprimé (12), qui forme une deuxième surface d'intersection (38) avec la surface de délimitation (34) et qui est formée parallèlement au premier joint soudé (30).

7. Assemblage optoélectronique (10) selon l'une des revendications 5 ou 6, qui présente au moins un deuxième composant optoélectronique (22) qui est disposé sur la première face (14) de la carte de circuit imprimé (12) et qui recouvre au moins partiellement la première surface d'intersection (36) et/ou la deuxième surface d'intersection (38) .

8. Assemblage optoélectronique (10) selon l'une des revendications ci-dessus, dans lequel le premier joint soudé (30) et/ou le second joint soudé (32) font saillie dans la carte de circuit imprimé (12) sur une profondeur correspondant à 5 % à 50 % de l'épaisseur de la carte de circuit imprimé (12) .

9. Assemblage optoélectronique (10) selon l'une des revendications précédentes, dans lequel une couche active du premier composant (20) et la première surface d'intersection (36) se chevauchent au moins partiellement.

10. Procédé de fabrication d'un assemblage optoélectronique (10), dans lequel
une carte de circuit imprimé (12) est fournie,
au moins un premier composant optoélectronique (20) est disposé sur une première face (14) de la carte de circuit imprimé (12),
une première surface (26) d'un dissipateur de chaleur (24) est disposée sur une deuxième face (16) de la carte de circuit imprimé (12) opposée à la première face (14), dans lequel une surface de délimitation (34) s'étend entre la deuxième face (16) et la première surface (26), et
la carte de circuit imprimé (12) est reliée directement et par liaison de matière au dissipateur thermique (24) au moyen d'au moins un premier joint soudé (30), le premier joint soudé (30) étant formé au moyen d'un rayon laser (60) qui est rayonné de l'extérieur sur une deuxième surface du dissipateur de chaleur (24) opposée à la carte de circuit imprimé (12), en ce que le premier joint soudé (30) forme une première surface d'intersection(36) avec la surface de délimitation (34), et en ce que le premier composant (20) chevauche au moins partiellement la première surface d'intersection (36), **caractérisé en ce que**, simultanément à la formation du premier joint soudé (30) au moyen du même faisceau laser (60) avec lequel le premier joint soudé (30) est formé, le premier composant (20) est relié à la carte de circuit imprimé (12) de manière matériellement liée.

11. Procédé selon la revendication 10, dans lequel le dissipateur thermique (24) et/ou la carte de circuit imprimé (12) sont refroidis pendant la formation du premier joint soudé (30).

12. Procédé selon l'une des revendications 10 ou 11, dans lequel la fumée (68) qui est produite pendant la formation du premier joint soudé (30) est extraite pendant la formation du premier joint soudé (30).

13. Procédé selon l'une des revendications 10 à 12, dans lequel au moins un deuxième joint soudé (32) est forme, au moyen duquel la carte de circuit imprimé (12) est reliée directement et par liaison de matière sur sa deuxième face (16) à la première surface (26) du dissipateur de chaleur (24), le deuxième joint soudé (32) étant formé au moyen d'un rayon laser (60) qui est rayonné de l'extérieur sur la deuxième surface du dissipateur de chaleur (24).
